# EUROPEAN PATENT SPECIFICATION

(11) **EP 2 689 456 B1**
(45) Date of publication and mention of the grant of the patent: **19.07.2017**
(21) Application number: 12702345.5
(22) Date of filing: 12.01.2012
(51) Int. Cl.: H01L 23/522

(54) **SYMMETRICAL CENTER TAP INDUCTOR STRUCTURE**
INDUKTORSTRUKTUR MIT EINEM SYMMETRISCHEN ZENTRUM
STRUCTURE D'INDUCTEUR À PRISE MÉDIANE SYMÉTRIQUE

(30) Priority: 21.03.2011 US 201113052310; 21.03.2011 US 201113052293
(43) Date of publication of application: 29.01.2014
(73) Proprietor: Xilinx, Inc., San Jose, California 95124 (US)
(72) Inventor: WU, Zhaoyin, D., San Jose, CA 95124 (US); JIANG, Xuewen, San Jose, CA 95124 (US); UPADHYAYA, Parag, San Jose, CA 95124 (US); JING, Jing, San Jose, CA 95124 (US); WU, Shuxian, San Jose, CA 95124 (US)
(74) Representative: Naismith, Robert Stewart
(86) International application number: PCT/US2012/021079
(87) International publication number: WO 2012/128832

(56) References cited:
- EP-A1- 1 213 762
- WO-A1-2009/101565
- US-A1- 2003 222 750
- US-A1- 2004 085 175
- US-A1- 2008 074 229
- US-A1- 2009 152 674

## Description

### FIELD OF THE INVENTION

One or more embodiments disclosed within this specification relate to integrated circuits (ICs). More particularly, one or more embodiments relate to a center tap inductor structure implemented within an IC.

### BACKGROUND

The frequency of signals associated with integrated circuits (ICs), whether generated within the IC or exchanged with devices external to the IC, has steadily increased over time. As IC signals reach radio frequency (RF) ranges exceeding a gigahertz, it becomes viable to implement inductor structures within ICs. Implementing an inductor structure within an IC, as opposed to using an external inductor device, typically reduces the manufacturing and implementation costs of the system requiring the inductor. IC inductor structures can be implemented within a variety of RF circuits such as, for example, low noise amplifiers (LNAs), voltage controlled oscillators (VCOs), input or output matching structures, power amplifiers, and the like. Many of these RF circuits, such as certain VCO architectures, can be implemented as differential circuits that rely on circuit and/or device symmetry to provide maximum circuit performance.

Although IC inductor structures are advantageous in many respects, IC inductor structures introduce various non-idealities not present with external or discrete inductors. For example, an IC inductor structure is typically surrounded by other semiconductor devices that can generate noise. As IC devices reside over a common substrate material that is conductive, signals and noise generated by an IC device can be coupled into an IC inductor structure built over the common substrate material. Although IC inductor structures are typically built within one or more metal interconnect layers that reside farthest from the substrate layer, finite parasitic capacitances exist between the substrate layer and the metal interconnect layer(s). These parasitic capacitances can couple signals between the IC inductor structure and the substrate layer. Further, eddy currents induced within the substrate layer by an IC inductor structure can generate losses that reduce the quality factor, or so called "Q," of the IC inductor structure.

Other non-idealities relate to the ability of interconnect lines routed in the vicinity of the IC inductor structure, particularly large ground and power supply lines, to couple signals both capacitively and inductively to the IC inductor structure. In addition, inductive coupling resulting from neighboring metal lines can alter the inductive value and self resonance of an IC inductor structure.

Each of the non-idealities described can interfere with the implementation of an IC inductor structure as a consistent and reproducible element whose parameters are independent of the IC environment within which the IC inductor structure resides.

US2004/085,175 describes an integrated circuit having an inducting device with a symmetric inductor. The inducting device comprises a first and second inductor. The first inductor is formed in a first conductive layer and is approximately symmetric about a plane of symmetry. The second inductor is formed in a second conductive layer that is at a select vertical distance from the first conductive layer. The second inductor is further approximately laterally aligned with the first inductor.

In particular, the first symmetric inductor portion includes turn portions 814, and 816, particularly half turns 814A, 816A, 814B and 816B. A center tap 809 is positioned along a plane of symmetry 904 and is electrically coupled to a turn portion 822. The device further comprises main leads 906 and 908 coupled to respective ends of respective half turn portions 814A, 814B.

US2008/074,229 describes an inductor device in an integrated circuit that includes a first winding portion, a bridge portion and a second winding portion. The integrated circuit has a first, a second, a third and a fourth metallization level. The first winding portion comprises a first metal line formed on the first metallization level and a second metal line formed on the second metallization level, the first metal line being electrically connected in parallel with the second metal line. The bridge portion comprises a third metal line formed on the third metallization level and a fourth metal line formed on the fourth metallization level, the third metal line being electrically connected in parallel with the fourth metal line. The second winding portion comprises a fifth metal line formed on the first metallization level and a sixth metal line formed on the second metallization level, the fifth metal line being electrically connected in parallel with the sixth metal line. The bridge portion electrically connects the first winding portion to the second winding portion.

WO2009/101565 describes figure of 8-shaped and clover-shaped inductor layouts that minimize an amount of crossing points in which symmetry is of relevance.

EP1213762 describes an insulation device that is integral with a weakly resistive substrate and includes a set of insulating trenches that are mutually parallel, and a set of series of insulating traverses having a depth close to that of the trenches. The trenches and the series of traverses contain a resistive material having its resistivity higher than that of the substrate. Each series of traverses is a transversal between two neighboring trenches, and is laid out so that the traverses of two adjacent series are not extensions of each other. The electric element is an inductor whose external contour demarcates an insulation surface, and the insulation device has a surface substantially identical to the insulation surface. US2009/0152674 describes a semiconductor device that contains a semiconductor substrate, an insulating film formed on the semiconductor substrate, an inductor formed over the semiconductor substrate while placing a portion of the insulating film in between, and a guard ring surrounding the inductor in a plan view and isolating the inductor from other regions. The guard ring contains an annular impurity diffused layer provided in the surficial portion of the semiconductor substrate. An annular electro-conductor is connected to the impurity diffused layer, and extended across a plurality of interconnect layers, up to a layer having a level of height not lower than the layer having the inductor provided therein.

### SUMMARY

Various aspects of the present invention are defined in the independent claims. Some preferred features are defined in the dependent claims.

One or more embodiments disclosed within this specification relate to integrated circuits (ICs) and, more particularly, to an inductor structure implemented within an IC.

Described herein by way of example is an inductor structure implemented within a semiconductor IC. The inductor structure can include a coil of conductive material that includes a center terminal located at a midpoint of a length of the coil. The coil can be symmetrical with respect to a centerline bisecting the center terminal. The coil can include a first differential terminal and a second differential terminal. The inductor structure can include a return line of conductive material coupled to the coil. The return line can be positioned on the centerline.

The inductor structure can include an isolation ring. The isolation ring can surround the coil and can be separated from the coil by approximately a constant and predetermined distance. The isolation ring can have a first end and a second end separated by a predetermined distance forming an opening. For example, the first end and the second end of the isolation ring can be equidistant from the centerline.

In another example, the isolation ring can be coupled to the return line at a location opposite the center terminal. When in a circuit in which the inductor structure is implemented, the isolation ring can be coupled, at a midpoint of a length of the isolation ring, to a virtual AC ground of the circuit.

In another example, no supply voltage interconnect and no ground interconnect can be located within the isolation ring. Further, no supply voltage interconnect and no ground interconnect can be permitted to cross the centerline within a predetermined distance of the isolation ring.

In a further example, the first differential terminal and the second differential terminal can each be located at an end of the coil opposite the center terminal. The return line can be located in a different conductive layer than the coil. A length of the return line can be approximately equal to a diameter of the coil at the centerline.

Additionally or alternatively, the inductor structure can include a patterned ground shield including a plurality of fingers implemented within an IC process layer located between the coil of conductive material and a substrate of the IC.

According to another example, the coil can be formed of a plurality of linear segments. For each of the plurality of linear segments of the coil, the plurality of fingers located below that linear segment can be substantially parallel and separated by a predetermined distance from one another. Each finger can be positioned substantially perpendicular to the linear segment of the coil beneath which the each finger is located.

In some examples, the isolation ring can comprise a low conductivity material and be coupled to one end of each finger.

Additionally or alternatively, the inductor structure can include an isolation wall comprising a high conductive material formed to encompass the coil and the patterned ground shield. The isolation wall can be coupled to one end of each finger. The isolation wall can be coupled to the substrate of the IC. For example, the isolation wall can be coupled to a P-type diffusion material disposed within the substrate of the IC, and the P-type diffusion material can couple the isolation wall to the substrate of the IC.

In some examples, the isolation wall includes a plurality of vertically stacked conductive layers. Each pair of adjacent, vertically stacked conductive layers can be coupled by a via. A highest conductive layer used to form the isolation wall can be implemented using a process layer at least as far from the substrate of the IC as a process layer used to form the coil. A lowest conductive layer used to form the isolation wall can be implemented using a process layer at least as close to the substrate of the IC as a process layer used to form the plurality of fingers.

Another example can include an inductor structure implemented within a semiconductor IC. The inductor structure can include a coil of conductive material having a center terminal located at a midpoint of a length of the coil. The coil can be symmetrical with respect to a centerline bisecting the center terminal. The coil can include a first differential terminal and a second differential terminal each located at an end of the coil opposite the center terminal. The inductor structure also can include an isolation ring surrounding the coil and separated from the coil by approximately a constant and predetermined distance. The isolation ring can include a first end and a second end separated by a predetermined distance forming an opening in the isolation ring.

The inductor structure also can include a return line of conductive material located in different conductive layer of the IC than the coil. The return line can be positioned on the centerline substantially within the coil. In one example, a length of the return line can be approximately equal to a diameter of the coil at the centerline.

The first end and the second end of the isolation ring can be equidistant from the centerline. The first end and the second end further can be located closer to the center terminal than either of the differential terminals of the coil. In another example, the isolation ring can be coupled to an end of the return line that is opposite the center terminal.

The isolation ring further can be coupled, at a midpoint of a length of the isolation ring, to a virtual AC ground when in a circuit in which the inductor structure is implemented.

In another example, no supply voltage interconnect and no ground interconnect can be located within the isolation ring. Further, no supply voltage interconnect and no ground interconnect can be permitted to cross the centerline within a predetermined distance of the isolation ring. Another example can include an inductor structure implemented within a semiconductor IC. The inductor structure can include a plurality of coils of conductive material including a center terminal located at a midpoint of a length of the plurality of coils. Each of the plurality of coils can be symmetrical with respect to a centerline bisecting the center terminal. The plurality of coils can include a first differential terminal and a second differential terminal each located at an end of the plurality of coils. The inductor structure can include an isolation ring surrounding the plurality of coils and separated from the plurality of coils by approximately a constant and predetermined distance. The isolation ring can include a first end and a second end separated by a predetermined distance forming an opening in the isolation ring.

The first end and the second end of the isolation ring can be equidistant from the centerline. The first end and the second end also can be located external to a portion of the plurality of coils opposite the center terminal, the first differential terminal, and the second differential terminal.

The center terminal can be located on a same side of the plurality of coils as, and between, the first and second differential terminals.

When in a circuit in which the inductor structure is implemented, the isolation ring can be coupled, at a midpoint of a length of the isolation ring, to a virtual AC ground of the circuit.

In another example, no supply voltage interconnect and no ground interconnect are located within the isolation ring. Further, no supply voltage interconnect and no ground interconnect can be permitted to cross the centerline within a predetermined distance of the isolation ring.

### BRIEF DESCRIPTION OF THE DRAWINGS

FIG. 1 is a circuit diagram illustrating an exemplary circuit implemented with a center tap inductor structure in accordance with an embodiment disclosed within this specification.
FIG. 2 is a first block diagram illustrating a topographical view of an inductor structure in accordance with another embodiment disclosed within this specification.
FIG. 3 is a second block diagram illustrating a graphical representation of an inductor structure in accordance with another embodiment disclosed within this specification.
FIG. 4 is a third block diagram illustrating a side view of an inductor structure in accordance with another embodiment disclosed within this specification.
FIG. 5 is a fourth block diagram illustrating a two turn center tap inductor structure in accordance with another embodiment disclosed within this specification.
FIG. 6 is a fifth block diagram illustrating a topographical view of an inductor structure in accordance with an embodiment disclosed within this specification.
FIGs. 7-1 and 7-1 are sixth and seventh block diagrams each illustrating a side view of an inductor structure in accordance with another embodiment disclosed within this specification.
FIG. 8 is a graph illustrating the influence of conductance of the material used to couple fingers of a patterned ground shield structure on the inductive and lossy characteristics of an IC inductor structure in accordance with another embodiment disclosed within this specification.
FIG. 9 is a eighth block diagram illustrating a topographical view of an inductor structure in accordance with another embodiment disclosed within this specification.
FIG. 10 is a ninth block diagram illustrating a topographical view of the inductor structure of FIG. 9 in accordance with another embodiment disclosed within this specification.
FIG. 11 is a tenth block diagram illustrating a topographical view of the inductor structure of FIG. 9 in accordance with another embodiment disclosed within this specification.
FIG. 12 is an eleventh block diagram illustrating a topographical view of the inductor structure of FIG. 9 in accordance with another embodiment disclosed within this specification.
FIG. 13 is a twelfth block diagram illustrating a topographical view of the inductor structure of FIG. 9 in accordance with another embodiment disclosed within this specification.
FIG. 14 is a thirteenth block diagram illustrating a topographical view of the inductor structure of FIG. 9 in accordance with another embodiment disclosed within this specification.

### DETAILED DESCRIPTION

While the specification concludes with claims defining features of one or more embodiments that are regarded as novel, it is believed that the one or more embodiments will be better understood from a consideration of the description in conjunction with the drawings. As required, one or more detailed embodiments are disclosed within this specification. It should be appreciated, however, that the one or more embodiments are merely exemplary of the inventive arrangements. Therefore, specific structural and functional details disclosed within this specification are not to be interpreted as limiting, but merely as a basis for the claims and as a representative basis for teaching one skilled in the art to variously employ the one or more embodiments in virtually any appropriately detailed structure. Further, the terms and phrases used herein are not intended to be limiting, but rather to provide an understandable description of the one or more embodiments disclosed herein.

One or more embodiments disclosed within this specification relate to integrated circuits (ICs) and, more particularly, to an inductor structure for use within an IC. In accordance with one or more embodiments disclosed herein, a center tap inductor structure can be implemented that includes a return line within the inductor structure. The inductor structure can be implemented with a single turn coil constructed symmetrically about a center line that bisects the coil. When implemented within a high frequency differential circuit, the center tap of the inductor structure can receive a current used to bias the high frequency differential circuit. The return line can be routed along the centerline of the single turn coil and used as a return path for the bias current to ground. In this manner, the bias current flowing within the circuit is returned to ground along the centerline of the inductor structure.

An isolation ring can be configured to surround the single turn coil of the inductor structure. The isolation ring can be implemented with an opening located where the isolation ring intersects the centerline. The opening prevents currents induced within the isolation ring, by the single turn coil coupling to the isolation ring, from circularly flowing within the isolation ring. Routing the return line along the centerline of the inductor structure and breaking the current path in the isolation ring produces an inductor structure with greater differential symmetry. In addition, the parameters of the inductor structure demonstrate less variability when exposed to the effects of inductive and capacitive coupling.

An inductor structure can be implemented that includes a patterned ground shield formed of groups of a plurality of parallel, conductive strips. The patterned ground shield of the inductor structure can isolate the electric field generated by current flow through the inductor structure from a substrate underlying the inductor structure. The patterned ground shield can be configured so as to not impede the magnetic field surrounding the coil(s) of the inductor structure.

The strips of the patterned ground shield can be coupled together at the outer perimeter of the patterned ground shield. A ring of conductive material can be used to couple the strips together. In an embodiment, the ring of conductive material can be formed to have a specified conductivity. The conductivity can be within one of a plurality of different conductivity ranges. By forming the ring of conductive material with a conductivity within a selected conductivity range, the quality factor, i.e., the "Q," of the inductor structure can be controlled and/or optimized. This ring of conductive material can comprise an isolation ring or an isolation wall, or both, as illustrated in the exemplary embodiments described below.

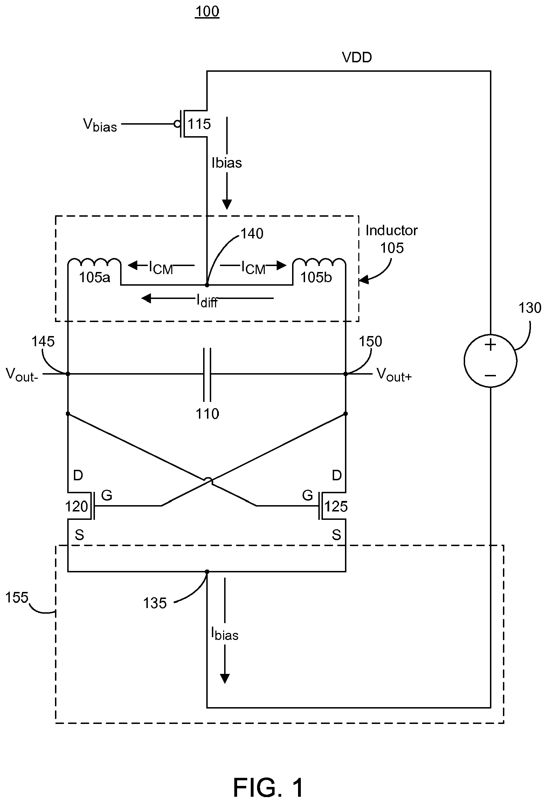

FIG. 1 is a circuit diagram illustrating an exemplary circuit 100 implemented with a center tap inductor in accordance with an embodiment disclosed within this specification. More particularly, circuit 100 can be a radio frequency (RF) differential circuit including a single turn center tap inductor structure. FIG. 1 is presented to illustrate electrical properties of a physical inductor structure and the non-idealities that are typically associated with an IC center tap inductor structure when implemented within an RF differential circuit such as circuit 100. It should be appreciated, however, that FIG. 1, being a circuit diagram, is not intended to convey or illustrate physical location, e.g., layout, of the various components shown. As used within this specification, a "layout" or "IC layout," can refer to a representation of an IC in terms of planar geometric shapes which correspond to the design masks that pattern the metal layers, the oxide regions, the diffusion areas, or other layers that form devices of the IC.

Circuit 100 represents a circuit architecture for a voltage controlled oscillator (VCO) within an IC. As shown, circuit 100 can include an inductor structure 105, a capacitor 110, a P-type metal oxide semiconductor (PMOS) current source 115, and N-type metal oxide semiconductor devices (NMOSs) 120 and 125. Within circuit 100, inductor structure 105 and capacitor 110 are coupled in parallel across nodes 145 and 150 to form an L-C tank circuit. The L-C tank circuit determines an oscillation frequency of the VCO implemented with circuit 100. The oscillation frequency of circuit 100 is a product of the value of inductor structure 105 and the value of capacitor 110 of the L-C tank. Within circuit 100, inductor structure 105 can be implemented as a center tap inductor structure. More particularly, inductor structure 105 can be implemented as a symmetrical single turn center tap inductor structure. As used within this specification, a "center tap" or "center terminal," refers to a coupling point made at a midpoint in a length of windings or coils of an inductor. In addition, inductor structure 105 can be a symmetrical center tap inductor structure, wherein inductor structure 105 is physically symmetrical on either side of a centerline that bisects a center terminal 140.

Although a continuous series of windings or coils, a center tap inductor structure can be modeled as two discrete inductor structures of equal value coupled in series. For example, in FIG. 1, inductor structure 105 is represented as two inductor structures coupled in series, denoted as inductors 105a and 105b. By implementing inductor structure 105 as a symmetrical center tap inductor structure coupled at the inductor midpoint, matching between inductors 105a and 105b can be improved. As circuit 100 is a differential circuit, improving the matching between inductors 105a and 105b can improve the differential symmetry and performance of circuit 100.

Center terminal 140 is coupled to a drain of PMOS current source 115. A source of PMOS current source 115 is coupled to a voltage source 130 having a voltage potential of VDD. A gate of PMOS current source 115 receives a bias voltage, denoted as V_{bias}. The voltage potential of V_{bias} can determine a quantity of bias current, denoted as I_{bias}, sourced by PMOS current source 115 to center terminal 140. Through center terminal 140, the current I_{bias} can flow into inductor structure 105.

Nodes 145 and 150 form the differential output of circuit 100. As such, the differential output voltage of circuit 100 is equal to the voltage difference between signals Vₒᵤₜ₊ and Vₒᵤₜ₋. A drain of NMOS 120 and a gate of NMOS 125 are coupled to node 145. A drain of NMOS 125 and a gate of NMOS 120 are coupled to node 150. A source of each of NMOSs 120 and 125 is coupled to node 135 and to a negative voltage potential of source 130 that is typically the ground potential of circuit 100. NMOSs 120 and 125, taken together, form a cross-coupled differential pair containing a positive feedback loop. The positive feedback loop has a closed path from the gate of NMOS 120 to the gate of NMOS 125 via the drain of NMOS 120 and back to the gate of NMOS 120 via the drain of NMOS 125.

In order to induce oscillation within circuit 100, a current I_{bias} can be injected into inductor structure 105 at center terminal 140. The current I_{bias} establishes a predetermined operating point within each of NMOSs 120 and 125. Properly designed to meet a set of oscillation conditions, for example, a gain of greater than one in the positive feedback loop of NMOSs 120 and 125, NMOSs 120 and 125 in conjunction with inductor structure 105 and capacitor 110 can combine to form an oscillator. In one or more embodiments, capacitor 110 can be implemented with a varactor, i.e., a voltage controlled variable capacitor, in order to vary the oscillation frequency of circuit 100 across a predetermined frequency range.

As current I_{bias} flows though inductor structure 105, current I_{bias} is divided between inductors 105a and 105b. For simplicity of understanding how current I_{bias} flows between inductors 105a and 105b, current I_{bias} can be divided into component currents of a common mode current, denoted as I_{CM}, and a differential current, denoted as I_{diff}. The current I_{CM} can be considered a quantity of common DC current flowing symmetrically within each of inductors 105a and 105b.

In illustration, in a balanced condition of circuit 100, i.e., (Vₒᵤₜ₊) - (Vₒᵤₜ₋) = zero volts, the current sourced through each of NMOSs 120 and 125 is approximately equal to one half of the current I_{bias}. Accordingly, the current flowing through each of inductors 105a and 105b is approximately equal to one half of the current I_{bias}. The current value of one half I_{bias} can be considered the common mode current sourced through each of NMOSs 120 and 125. As circuit 100 oscillates, the current flowing through NMOS 120 increases as current flowing through NMOS 125 decreases. Then, in succession, the current flowing through NMOS 120 decreases as the current flowing through NMOS 125 increases. Thus, the current flowing through inductor 105a increases as the current flowing through inductor 105b decreases. Then, in succession, the current flowing through inductor 105a decreases as the current flowing through inductor 105b increases.

This directional change in the current flow through inductors 105a and 105b can be considered the AC differential current, I_{diff}, flowing through inductor structure 105. As inductor structure 105 is a center tap, single turn inductor structure and, accordingly, inductors 105a and 105b are physically symmetrical to each other, the current I_{diff} represents an asymmetric flow of current through inductors 105a and 105b. For example, PMOS current source 115 of circuit 100 can be biased to generate a current I_{bias} equal to approximately 100mA. In that case, the current I_{CM} flowing through each of inductors 105a and 105b is equal to approximately 50mA.

At a subsequent time T1, as circuit 100 oscillates, approximately 75mA can be flowing out of inductor 105a to node 145 and approximately 25mA can be flowing out of inductor 105b to node 150. In that case, a current I_{diff} of approximately 25mA can be considered to be flowing from node 150 to node 145 through inductor structure 105. Although illustrated in FIG. 1 with an arrow indicating a single direction for current I_{diff}, current I_{diff} can flow in either direction through inductor structure 105. The distinction between common mode current and differential current is significant to the performance of inductor structure 105 as the current I_{CM} flows symmetrically on either side of center terminal 140 though inductor structure 105 while the current I_{diff} flows asymmetrically, in either direction, across inductor structure 105.

The current flowing through each of NMOSs 120 and 125 is summed at node 135 and returned to source 130. As circuit 100 is a closed path between the positive voltage potential of source 130 and the negative voltage potential of source 130, the current received at center terminal 140 is equal to the current returned to the negative voltage potential of source 130. Accordingly, the current returned to the negative voltage potential of source 130 is equal to I_{bias}.

Return 155 within circuit 100 of FIG. 1 represents the return pathway for current from the source of each of NMOSs 120 and 125 to the negative voltage potential of source 130. When implemented as a physical circuit within an IC, return 155 represents one or more segments of interconnect material that couple the source of each of NMOSs 120 and 125 to a ground bus implemented within a conductive layer of the IC located some finite distance from the source of each of NMOSs 120 and 125.

Depending upon the location and manner of routing the interconnect material that couples the source terminal of each of NMOSs 120 and 125 to source 130, the interconnect material of return 155 can couple to inductor structure 105. The manner of this coupling can be both capacitive and inductive. Asymmetries in routing the interconnect of return 155 to return current I_{bias} to source 130, relative to inductor structure 105, can result in asymmetric coupling of return 155 to inductor structure 105. In addition, asymmetries in the current flowing within differing segments of the interconnect material of return 155 can result in asymmetric inductive coupling of return 155 to inductor structure 105.

The coupling of other devices and physical features, e.g., metal interconnect, within a physical implementation of circuit 100 in an IC can impact circuit parameters of inductor structure 105 and, accordingly, circuit 100. In illustration, other IC devices and physical features coupling to inductor 105 can alter the inductance value of inductor structure 105, thereby shifting the center frequency of circuit 100. Asymmetric coupling of return 155 to inductor structure 105 can affect the inductive value of one of inductors 105a and 105b more significantly than the other, thereby degrading the differential integrity of circuit 100. In addition, asymmetric coupling of common mode noise to inductor structure 105 can couple more of the common mode noise to one of inductors 105a and 105b than the other. The asymmetric coupling of common mode noise, noise that is inherently reduced by a differential circuit, to inductors 105a and 105b can result in common mode noise being converted to differential noise.

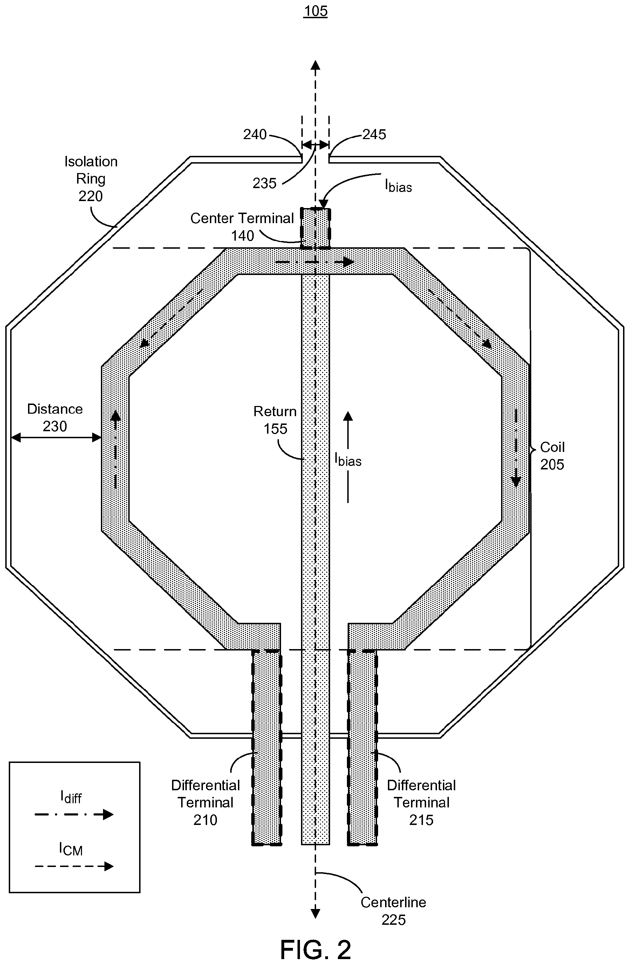

FIG. 2 is a second block diagram illustrating a topographical view of an inductor structure 105 in accordance with another embodiment disclosed within this specification. FIG. 2 illustrates a physical layout representation, as implemented within an IC, of the single turn, center tap inductor structure 105 discussed with reference to FIG. 1. As such, like numbers will be used to refer to the same items throughout this specification. Inductor structure 105 can include a coil 205, a center terminal 140, differential terminals (terminals) 210 and 215, a return 155, and an isolation ring 220.

Although denoted as four distinct objects for descriptive purposes within this specification, coil 205, center terminal 140, and terminals 210 and 215 are coupled together and represent one continuous area of conductive material. In addition, though implemented as one continuous area or segment of conductive material, coil 205, center terminal 140, and terminals 210 and 215 can be implemented within one or more different conductive layers of the IC. The conductive layers can be coupled together with one or more vias to create one continuous conductive pathway.

Coil 205 can be implemented as a symmetrical, single turn coil of inductor structure 105. A centerline 225 can be determined that symmetrically bisects coil 205. Each segment of coil 205 residing on a particular side of centerline 225 can represent a physical layout of one of inductors 105a and 105b as described with reference to FIG. 1. Although implemented as an octagonal coil within FIG. 2, coil 205 can be implemented in any of a variety of forms or shapes that can be implemented using available IC manufacturing processes so long as the symmetry of coil 205 about centerline 225 is retained. As such, the implementation of coil 205 as an octagonal coil within inductor structure 105 is provided for clarity and descriptive purposes only, and is not intended to be limiting.

When implemented within an RF differential circuit, e.g., circuit 100 of FIG. 1, inductor structure 105 can receive bias current I_{bias} at center terminal 140. As noted earlier within this specification, center terminal 140 is located at the midpoint of the length of coil 205, thereby assuring that each side of coil 205 is symmetric and of equal inductive value. Each of terminals 210 and 215 can be coupled to a differential output node of the RF differential circuit in which inductor structure 105 is implemented. As described earlier within this specification, when the RF differential circuit is in a balanced condition, the common mode current I_{CM} that is sourced from each of terminals 210 and 215 is approximately equal to one half of I_{bias}.

As the RF differential circuit switches state, a differential current, I_{diff}, can alternately flow in either direction within coil 205. As I_{diff} alternates in direction of flow, the quantity of current associated with I_{diff} also varies. With the current within coil 205 described in this manner, the current flowing through coil 205 can be represented as the sum of I_{CM} and I_{diff} flowing through terminals 210 and 215 at any particular time.

For example, center terminal 140 can receive a current I_{bias} of approximately 100 mA. As a result, the common mode current flowing through each of terminals 210 and 215 can be approximately 50mA. At a time T1, approximately 75 mA can be flowing out of terminal 210 and approximately 25 mA can be flowing out of terminal 215. In that case, at time T1, a differential current of approximately 25mA flows in coil 205 from terminal 215 to terminal 210. The distinction between common mode current and differential current is significant to the performance of inductor structure 105 as I_{CM} flows symmetrically on either side of centerline 225 while I_{diff} flows alternately in either direction across centerline 225.

Return 155 can be implemented with a segment of conductive material disposed within a conductive layer of the IC manufacturing process used to implement inductor structure 105. In one embodiment, the length of return 155 can be approximately equal in length to a diameter of coil 205 the centerline 225 and further can be located substantially within coil 205. The conductive layer in which return 155 is implemented can be a conductive layer that is different from the conductive layer used to implement coil 205, center terminal 140, and/or terminals 210 and 215. Implementing return 155 in this manner prevents one or more of coil 205, center terminal 140, or differential terminals 210 and 215 from being coupled to return 155. Further, through return 155, the current flowing through each side of coil 205, is summed and returned to source 130, which can be located at the end of return 155 adjacent to, or near, center terminal 140. Return 155 can be disposed on centerline 225, thereby symmetrically bisecting inductor structure 105, i.e., coil 205. The implementation of return 155 on centerline 225 assures that current used within inductor structure 105 is routed symmetrically back through inductor structure 105 to the lowest potential. Additionally, the implementation of return 155 on centerline 225 assures that the conductive material used to return the current used within inductor structure 105 back to the lowest potential is routed symmetrically through inductor structure 105.

Implementing return 155 in this manner assures that any coupling induced by returning bias current to the lowest potential or by the interconnect material used to return bias current to the lowest potential is symmetrically applied to either side of coil 205 as bisected by centerline 225. Retaining this symmetry allows the retention of the matched inductive properties between each side of coil 205. As each section of coil 205 residing on either side of centerline 225 implements an individual inductor, e.g., inductors 105a and 105b as described with reference to FIG.1, the matching of the inductive value of each side of coil 205 is required to assure differential signal balance within a circuit implemented with inductor structure 105. Any common mode noise coupled to coil 205 asymmetrically to one side of centerline 225 can be converted to a differential noise that can appear within the differential output signal of any differential circuit in which inductor structure 105 is implemented.

Isolation ring 220 can include one or more substrate taps coupled to a segment of conductive material residing within a conductive layer of an IC manufacturing process used to implement inductor structure 105. In another embodiment, the lowest residing conductive layer of the IC manufacturing process, and therefore, the conductive layer vertically closest to the substrate taps, can be used to implement the segment of conductive material that is coupled to the substrate tap(s). The conductive material of isolation ring 220 can be coupled via one or more interconnects to a lowest voltage potential available within the IC in which inductor structure 105 is implemented, e.g., ground. In one aspect, isolation ring 220 can be said to electromagnetically couple to coil 205.

Isolation ring 220 can surround coil 205 at a constant and predetermined distance 230 from an outer perimeter of coil 205. For example, coil 205 and isolation ring 220 can be concentric with respect to one another. Coil 205 and isolation ring 220 further can have a same shape despite isolation ring 220 being sized to surround coil 205 and being implemented within different conductive layers of the IC.

As IC inductor structures reside over a conductive substrate material that is common to the entire IC, noise from surrounding devices can be injected into the substrate material residing directly beneath the inductor structure. The coils of an inductor structure are generally implemented within the conductive layer(s) farthest from the substrate layer and are separated from the substrate layer by one or more dielectric layers. Despite this isolation, both inductive and capacitive coupling can exist between the coils of the conventional inductor structure and the underlying substrate. For this reason, isolation rings can be located around the inductor structure and coupled to a common substrate voltage potential such as, for example, the ground potential of the IC. Coupling the substrate underlying the inductor structure to ground improves isolation of the underlying substrate from substrate noise injected by devices surrounding the inductor structure.

Typically, the isolation rings used within a conventional IC inductor structure form a continuous substrate ring surrounding the inductor coils of the conventional IC inductor structure. As the conventional isolation ring is continuous, it forms a coil surrounding the coils of the conventional IC inductor structure. As a result, a mutual inductance exists between the coils of the conventional IC inductor structure and the coil formed by the conventional isolation ring. Through mutual inductance, a time varying differential current within the conventional IC inductor structure can generate a magnetic field that induces a current flow within the conventional isolation ring. The current generated within the conventional isolation ring generates a magnetic field that opposes the current flow within the conventional IC inductor structure. This opposing magnetic field reduces the absolute inductive value for the conventional IC inductor structure when operating within a circuit.

As such, the mutual inductance between the conventional isolation ring and the conventional IC inductor structure decreases the inductive value of the conventional IC inductor structure. In addition, as the distance between the conventional isolation ring and the coils of the conventional inductor structure decreases, the mutual inductance between the conventional isolation ring and the coils of the conventional inductor structure increases, and the absolute inductive value of the conventional IC inductor structure decreases. The reduction in the inductive value of the conventional IC inductor structure from inductive coupling to the conventional isolation ring can approach 20 percent of the inductive value of the conventional IC inductor structure in the absence of the conventional isolation ring.

To counter the effect of the conventional isolation ring on inductance values, isolation ring 220 includes an opening that creates a discontinuity within isolation ring 220. Unlike the conventional isolation ring, isolation ring 220 does not form a continuous coil surrounding coil 205. Ends 240 and 245 of isolation ring 220 are proximate to center terminal 140, e.g., at an opposing end of inductor structure 105 from differential terminals 210 and 215, and are separated by a predetermined distance 235 defining the opening. In another embodiment, the opening can be centered over centerline 225. In that case, each of ends 240 and 245 of isolation ring 220 can be equidistant from centerline 225. As illustrated, the opening is aligned with center terminal 140 on centerline 225, e.g., aligned on a same axis. A portion of isolation ring, e.g., a location opposite the opening, can be coupled to return 155, as will be illustrated in greater detail within this specification.

The opening in isolation ring 220 can inhibit the circulation of current around isolation ring 220 by breaking the current pathway through isolation ring 220. The decrease in current flow within isolation ring 220 can reduce the impact of inductive coupling between coil 205 and isolation ring 220 upon the inductive value of inductor structure 105. For example, the inclusion of the opening defined by distance 235 between ends 240 and 245 within isolation ring 220 can reduce the effect that any variation in distance 230 has upon the inductive value of inductor structure 105.

Similar to the way in which isolation ring 220 forms a coil that interacts with inductor structure 105, segments of conductive material used to interconnect circuit blocks within an IC can form coils that interact with inductor structure 105. In particular, power supply lines within an IC, e.g., VDD and ground, which are typically implemented with large areas of conductive material, are more likely to interact with inductor structure 105. In order to form a coil that interacts with inductor structure 105, a power supply line must bisect coil 205 of inductor structure 105 in a manner that crosses centerline 225. When the power supply line remains on one side of centerline 225, the impact of differential current flowing across differential terminal 210 and 215 on the power supply line is minimal.

By allowing a supply line to cross centerline 225, differential currents flowing across coil 205 can induce current within the power supply line that crosses centerline 225. The current induced within the power supply line can generate magnetic fields that affect the inductive value of inductor structure 105. For this reason, when implemented within an IC layout, no power supply lines of the IC can reside within a perimeter defining inductor structure 105, or within a predetermined spacing from the perimeter defining inductor structure 105, that crosses centerline 225. In one embodiment, isolation ring 220, e.g., an outer edge of isolation ring 220, can be the perimeter defining inductor structure 105.

By implementing return 155, the opening in isolation ring 220, and preventing supply lines from crossing centerline 225 as described, a center tap inductor structure can be implemented that exhibits greater differential symmetry and a more stable inductive value. The use of the various structural elements described with reference to FIG. 2, a reduction in the variation of the inductive value of inductor structure 105 to approximately 2 percent of the designed inductive value can be achieved.

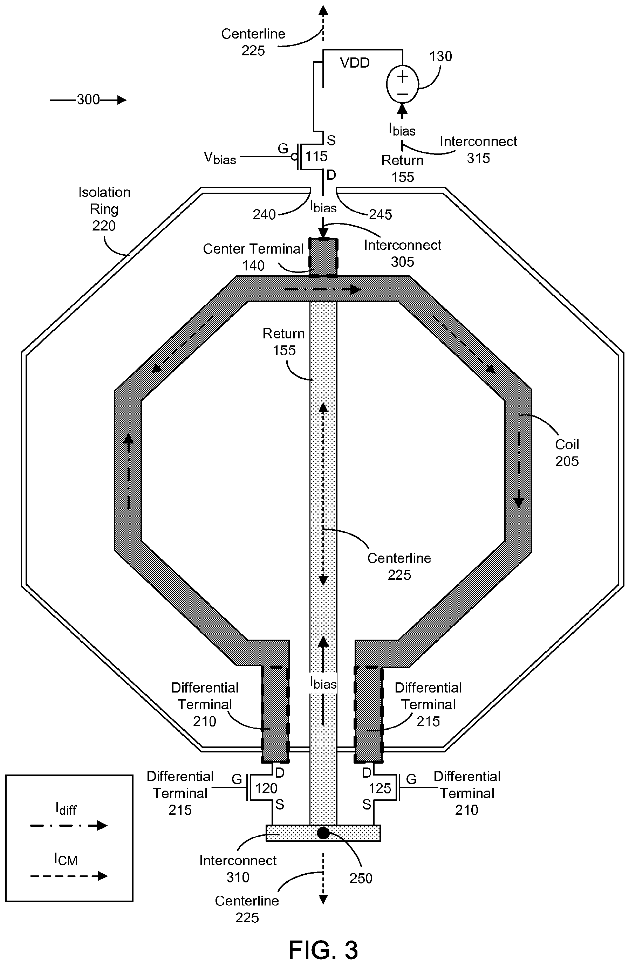

FIG. 3 is a second block diagram providing a graphical representation of an inductor structure in accordance with another embodiment disclosed within this specification. More particularly, FIG. 3 illustrates further aspects of inductor structure 105. Accordingly, FIG. 3 is intended to provide a better understanding of electrical and electromagnetic properties of inductor structure 105 and the influence of those properties upon the operation of circuit 100 of FIG. 1. As such, circuit diagram representations of components such as PMOS 115, NMOSs 120 and 125, and VDD are superimposed to illustrate the operational context in which inductor structure 105 exists and operates within circuit 100.

Referring to FIG. 3, a drain terminal of PMOS 115 is coupled to center terminal 140 via an interconnect 305. As previously described within this specification, PMOS 115 functions as a current source for the current I_{bias} from a positive voltage potential of source 130 to circuit 100. When implemented within an IC layout, interconnect 305 can be routed to inductor structure 105 along centerline 225, thereby retaining the structural and current symmetry within inductor structure 105.

Differential terminal 210 is coupled to a drain terminal of NMOS 120. A gate terminal of NMOS 120 is coupled to differential terminal 215. Differential terminal 215 is coupled to a drain terminal of NMOS 125. A gate terminal of NMOS 125 is coupled to differential terminal 215. Implemented in this manner, NMOSs 120 and 125 form a cross-coupled differential pair. The source terminal of each of NMOSs 120 and 125 is coupled to interconnect 310. The common mode and differential current flowing through the source terminal of each of NMOSs 120 and 125, when summed within interconnect 305, is approximately equal to I_{bias}. Interconnect 310 graphically represents the metal interconnect necessary to couple the source terminal of each of NMOSs 120 and 125 to return 155. In order to retain the structural and current symmetry within inductor structure 105, interconnect 310 can be symmetrically coupled to a first end of return 155 adjacent to differential terminals 210 and 215.

A second end of return 155, adjacent to center terminal 140, can be coupled to a negative voltage potential of source 130. Interconnect 315 is used to couple return 155 to the negative voltage potential of source 130. Interconnect 315 can be routed out of inductor structure 105 along centerline 225 to source 130. Coupled in this manner, current I_{bias} can be returned via return 155 and interconnect 315 to source 130. For example, interconnect 315 can be located in a different conductive layer to facilitate routing along central line 225. In addition, routing interconnects 305, 310, and 315 in this manner assures that current I_{bias} is routed to flow symmetrically into, and out of, inductor structure 105 along centerline 225. This symmetric routing approach prevents the formation of loops within inductor structure 105 that can couple to coil 205 that can vary the total inductance value of inductor structure 105 or inject external noise into inductor structure 105.

The coupling of substrate noise can be further minimized by the coupling of isolation ring 220 to return 155 at location 250. Coupling isolation ring 220 to return 155 at location 250 electrically bisects isolation ring 220 into two symmetric segments about centerline 225. Location 250, also representing an electrical node, can correspond to a virtual AC ground of circuit 100 for differential current flowing within coil 205 and accordingly, induced current within isolation ring 220. As used within this specification, the term "virtual AC ground," refers to a node of a circuit that is maintained at a steady voltage potential when sourcing or sinking AC current without being directly physically coupled to a reference voltage potential. Coupling isolation ring 220 to the virtual AC ground at location 250 minimizes the ability of isolation ring 220 to form a loop that interacts with any segment of coil 205. In addition, coupling the isolation ring 220 in this manner minimizes the influence of isolation ring 220 upon the inductive value of inductor structure 105.

The example illustrated within FIG. 3 is not intended to limit the one or more embodiments disclosed within this specification. For example, various devices illustrated in circuit schematic form can be replaced with one or more other passive and/or active devices. In this regard, for example, differential terminal 210 and differential terminal 215 can be coupled to location 250 and return 155 through one or more active devices, passive devices, or combinations of active and passive devices other than those shown. In general, the devices through which differential terminal 210 couples to return 155 will be the same as the devices through which differential terminal 215 couples to return 155, though this need not be the case. In similar fashion, center terminal 140 can couple to return 155 through one or more other types of circuit elements that are different from those illustrated in FIG. 3.

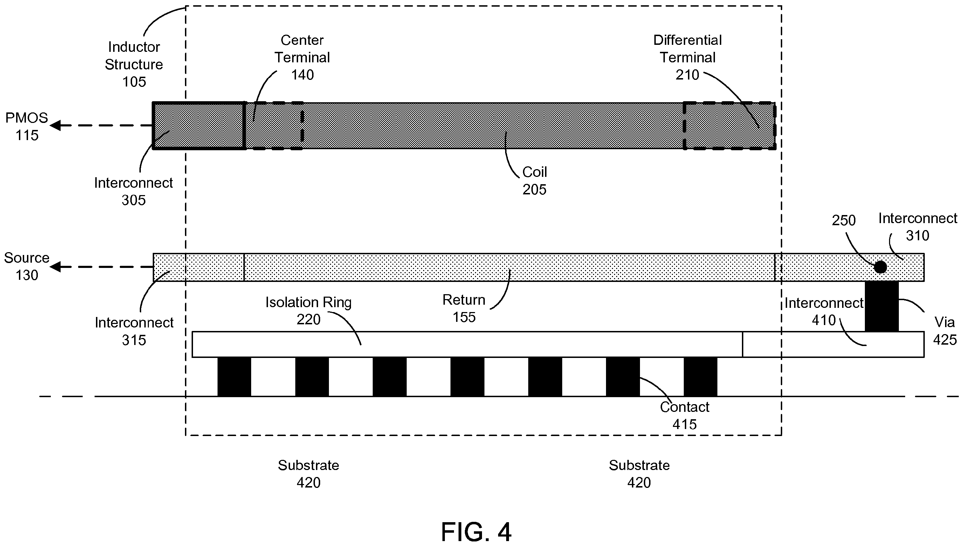

FIG. 4 is a third block diagram providing a side view of an inductor structure in accordance with another embodiment disclosed within this specification. FIG. 4 shows a side view of inductor structure 105 of FIG. 3 taken from the perspective of directional arrow 300. It should be noted that within FIG. 4, being a side view, one or more objects visible within FIG. 3 may not be visible within FIG. 4. Similarly, one or more objects that appear within FIG. 4 may not be visible within FIG. 3.

Referring to FIG. 4, three distinct conductive layers are used to implement the elements of inductor structure 105. Although implemented with three conductive layers, inductor structure 105 can be implemented with one or more additional conductive layers. As such, the implementation of inductor structure 105 with three conductive layers within this specification is provided for clarity and descriptive purposes only, and is not intended to be limiting. For example, inductor structure 105 can be implemented using four conductive layers. In that case, coil 205 can be implemented using two adjacent conductive layers coupled together by vias. In this manner, the quality factor, i.e., Q, of coil 205 can be improved by reducing the series resistance associated with coil 205.

Continuing with FIG. 4, center terminal 140, coil 205, and differential terminal 210 are implemented with a single continuous segment of conductive material within a conductive layer farthest from a substrate layer shown as substrate 420. It should be noted that within FIG. 4, differential terminal 215 is obstructed from view by differential terminal 210.

Return 155 is implemented within a conductive layer residing between the conductive layer used to implement coil 205 and substrate 420. In the example pictured in FIG. 4, return 155 is implemented within a conductive layer between the conductive layer in which coil 205 is implemented and the conductive layer in which isolation ring 220 is implemented. Generally, inductors are implemented within ICs using the conductive layer(s) farthest from substrate 420. Typically, these upper conductive layer(s) of an IC manufacturing process are thicker than lower residing conductive layers and, as a result, create inductors with lower series resistance and higher Q. Although implemented below coil 205 as shown in FIG. 4, return 155 also can be implemented within one or more conductive layers that reside above the conductive layer(s) used to implement coil 205. As such, the implementation of return 155 as illustrated within FIG. 4 of this specification is provided for clarity and descriptive purposes only, and is not intended to be limiting.

Interconnect 305 represents a region of conductive material that couples center terminal 140 of inductor structure 105 to a drain terminal of PMOS 115. Interconnect 310 represents a region of conductive material that couples return 155 to a source terminal of each of NMOSs 120 and 125. Interconnect 315 represents a region of conductive material that couples return 155 to a positive potential of source 130. Although illustrated as a single layer of conductive material, each of interconnects 305, 310, and 315 can be implemented using one or more conductive layers and one or more vias that couple adjacent conductive layers to form each respective one of interconnects 305, 310, and/or 315. As such, the implementation of each of interconnects 305, 310, and 315 with a single region of conductive material within this specification is provided for clarity and descriptive purposes only, and not is intended to be limiting.

Isolation ring 120 is implemented within a conductive layer residing closest to substrate 420. Each contact 415 couples a segment of isolation ring 120 to an underlying area of substrate 420. Although implemented within the conductive layer nearest to substrate 420, isolation ring 220 can be implemented within any conductive layer(s) available within an IC manufacturing process. As such, the implementation of isolation ring 220 in the conductive layer closest to substrate 420 and the number of contacts 415 as illustrated within FIG. 4 is not intended to be limiting.

Interconnect 410 represents a region of conductive material that couples isolation ring 220 to interconnect 310. Interconnect 410 is coupled to interconnect 310 at location 250 with one or more of vias 425. Accordingly, though illustrated as single layer of conductive material, interconnect 410 can be implemented as one or more conductive layers that couple interconnect 410 to interconnect 310.

In one or more embodiments, location 250 can be located at an AC virtual ground for the circuit in which inductor structure 105 is implemented. In that case, interconnect 410 can be physically connected to isolation ring 220 at location 250 so that isolation ring 220 is symmetrically bisected at a midpoint of the length of isolation ring 220 along the centerline of inductor structure 105. Coupling isolation ring 220 to interconnect 310 in this manner can minimize the size any loop formed by isolation ring 220 that may couple to a segment of coil 205. Minimizing the coupling of loops formed by isolation ring 220 to coil 205 reduces any variability in the induction value of inductor structure 105 that may be caused by the proximity of isolation ring 220 to coil 205.

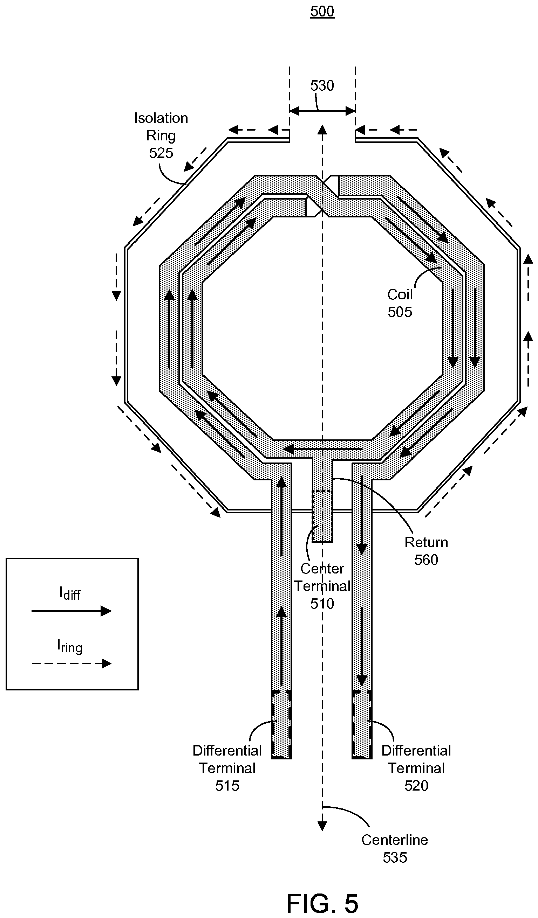

FIG. 5 is a fourth block diagram illustrating a two turn center tap inductor structure 500 in accordance with another embodiment disclosed within this specification. Inductor structure 500 illustrates the use of an isolation ring feature, as described with this specification as applied to a center tap inductor structure implemented with two or more turns. Inductor structure 500 can be used within differential RF circuits as described with reference to inductor structure 105 of FIG. 1. FIG. 5 illustrates further aspects and performance improvements that result from providing a symmetric opening within an isolation ring surrounding inductor structure 500.

Inductor structure 500 can include a coil 505, a center terminal 510, differential terminals (terminals) 515 and 520, and an isolation ring 525. As inductor structure 500 is intended for use within a differential RF circuit, generally, a bias current is received at center terminal 510. The portion 560 of conductive material coupling center terminal 510 to coil 505 can be considered the return or part of the return of inductor structure 500 located on center line 535. Thus, the return shown in FIG. 5 structurally differs from return 155 of FIGs. 1-4 and may correspond, for example, to the interconnection between elements 115 and 140 in FIG. 1. A portion of the bias current is output to the differential RF circuit at each of terminals 520 and 515. Although referenced as four distinct objects for descriptive purposes within this specification, coil 505, center terminal 510, and terminals 515 and 520 are coupled together and represent one continuous area or segment of conductive material. In addition, each of coil 505, center terminal 510, and/or terminals 515 and 520 can be implemented within one or more different conductive layers of the IC. The conductive layers can be coupled together with one or more vias to create one continuous conductive pathway.

Coil 505 is implemented as a symmetrical two turn coil of inductor structure 500. A centerline 535 can be determined that symmetrically bisects coil 505. Although implemented as a two turn octagonal coil within FIG. 5, coil 505 can include two or more turns implemented in any of a variety of forms or shapes allowable by an IC manufacturing process so long as the symmetry of coil 505 is retained about centerline 535. As such, the implementation of coil 505 as a two turn octagonal coil within inductor structure 500 is provided for clarity and descriptive purposes only, and is not intended to be limiting. In another embodiment, for example, the turns of coil 505 can be stacked with each turn of the coil implemented within a differing conductive layer of the IC. Each turn implemented within a different conductive layer can be coupled to a turn in an adjacent conductive layer by one or more vias to form a continuous coil.

Isolation ring 525 can include one or more substrate taps coupled to a segment of conductive material residing within a conductive layer of an IC manufacturing process used to implement inductor structure 500. In another embodiment, the lowest conductive layer of the IC manufacturing process, and therefore, the conductive layer vertically closest to the substrate taps, can be used to implement the segment of conductive material that is coupled to the substrate tap(s). The conductive material of isolation ring 525 can be coupled through interconnect material within the IC to a lowest voltage potential available within the IC in which inductor structure 500 is implemented, e.g., ground. Isolation ring 525 can surround coil 505 at a constant and predetermined distance from an outer perimeter of coil 505. In another embodiment, isolation ring 525 can be coupled at the midpoint of the length of isolation ring 525 to a virtual AC ground located within the circuit in which inductor structure 500 is implemented.

FIG. 5 illustrates the influence of mutual inductance between coil 505 and isolation ring 525 upon current flow within coil 505 and isolation ring 525. Within coil 505, I_{diff}, being a time varying differential current, flows from terminal 515 to terminal 520. As noted within this specification, unlike common mode current that flows symmetrically in either direction away from center terminal 510, I_{diff} flows across inductor structure 500. As such, I_{diff} flows asymmetrically through inductor coil 505 with respect to centerline 535. The flow of I_{diff} though inductor structure 500 generates a magnetic field that induces a current within isolation ring 525, denoted as I_{ring}, that flows in the opposite direction of I_{diff}.

Current I_{ring} generates a magnetic field that opposes the flow of current I_{diff} through coil 505. As previously discussed within this specification, in conventional IC inductor structures the unimpeded flow of current within an isolation ring can impact the inductive value of the conventional IC inductor structure. The opening of length 530 within isolation ring 525 serves to break the pathway for current I_{ring} flowing within isolation ring 525. Within FIG. 5, the length of the arrows used to represent current I_{ring} illustrates the current density of current I_{ring} at various locations within isolation ring 525. Referring to FIG. 5, the current density of current I_{ring} is lowest within locations nearest to the opening and highest within locations farthest from the opening.

Accordingly, the magnetic field generated within isolation ring 525 by current I_{ring} is weakest at locations nearest to the opening and strongest at locations farthest from the opening. As a result, the coupling between coil 505 and isolation ring 525 is weakest at locations nearest to the opening and strongest at locations farthest from the opening. Although the current density within isolation ring 525 decreases at locations nearest to the opening, the variation in current density is symmetric within isolation ring 525 on either side of the opening within isolation ring 525 as bisected by centerline 535. Locating the center of the opening along centerline 535 assures the variation in the current density of current I_{ring} and, accordingly, the level of coupling between coil 505 and isolation ring 525, is symmetric within inductor structure 500 with respect to centerline 535.

To illustrate the importance of the opening being symmetrically bisected by centerline 535, assume isolation ring 525 is rotated clockwise 90 degrees. As coupling between coil 505 and isolation ring 525 is weakest near the opening, the coupling between coil 505 and isolation ring 525 is weaker within the side of coil 505 that includes terminal 520 than the side of coil 505 that includes terminal 515. The asymmetry in the coupling between coil 505 and isolation ring 525 created by not centering the opening within isolation ring 525 over centerline 535 can lead to the conversion of common mode signals to differential signals.

Continuing with the previous illustration in which isolation ring 525 is rotated clockwise 90 degrees, a ground potential coupled to isolation ring 525 can contain a quantity of noise. The noise signal can be coupled by isolation ring 525 to coil 505. As the rotation of the opening results in asymmetric levels of coupling between each side of coil 505 and isolation ring 525, more of the noise signal is coupled to the side of coil 505 containing terminal 515 than the side containing terminal 520. The difference in the power of the noise signal within one side of coil 505 from the other side of coil 505 appears as a differential noise signal within the circuit in which inductor structure 500 is implemented.

Centering the opening of isolation ring 525 over centerline 535 assures that a noise signal is symmetrically coupled to each side of coil 505. In that case, the noise signal appears as a common mode signal which is inherently cancelled at some level by a typical differential circuit. The same coupling asymmetries can also influence the inductive value match of the dual inductors inherent within inductor structure 500.

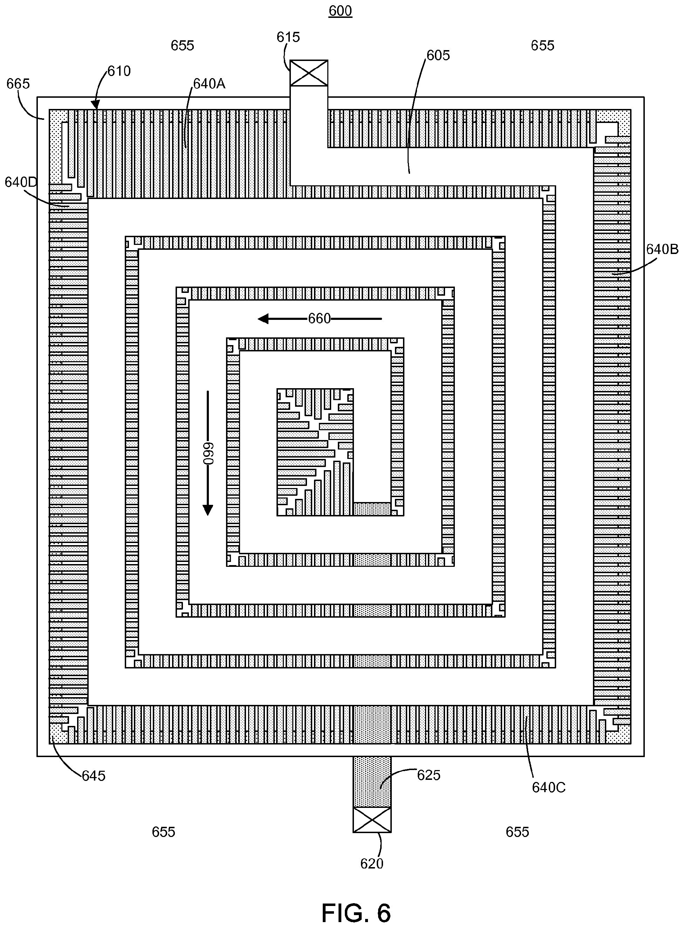

FIG. 6 is a fifth block diagram illustrating a topographical view of an inductor structure 600 for use within an IC in accordance with an embodiment disclosed within this specification. Inductor structure 600 can be implemented within an IC, e.g., as an IC inductor structure. As shown, inductor structure 600 can include a coil 605 and a patterned ground shield (PGS) structure 610. PGS structure 610 can provide isolation from substrate generated noise. Further, PGS structure 610 can serve to improve the "Q" of inductor structure 600.

Coil 605 can include a terminal 615, a terminal 620, and an interconnect 625 coupled to coil 605 using a via (not shown). Coil 605 can be implemented within one or more of a variety of process layers of an IC manufacturing process containing a high conductivity material. In an embodiment, coil 605 of inductor structure 600 can be implemented within the process layers containing the most conductive material of the IC manufacturing process. For example, the metal layers of the IC manufacturing process that are farthest from substrate 655 typically are considered highly, if not the most, conductive process layers and can be used to implement coil 605. It should be appreciated that, while illustrated as being formed in a single metal layer, coil 605 can be formed of two or more stacked metal layers that are coupled to one another using one or more vias.

Terminals 615 and 620 are located at distal ends of inductor structure 600. Terminals 615 and 620 can be used to couple inductor structure 600 to one or more other circuit elements within the IC in which inductor structure 600 is implemented. To make terminal 620 available outside an outer perimeter of coil 605, interconnect 625 can be formed using a metal layer that is not used to implement any turns of coil 605. Accordingly, the inner-most turn of coil 605 can be coupled to interconnect 625 using one or more vias as noted.

PGS structure 610 can be characterized by fingers 640. In an embodiment, coil 605 can be concentric with isolation ring 645 and isolation wall 665. For purposes of illustration, reference to isolation ring 645 within this specification also can refer to any contacts used to couple isolation ring 645 to metal structures located above isolation ring 645 unless otherwise indicated. Within FIG. 6, isolation wall 665 is immediately adjacent to isolation ring 645 with no intervening space. In another embodiment, however, isolation wall 665 can be larger than shown so that a substantially constant distance separates an outer edge of isolation ring 645 and an inner edge of isolation wall 665. In still another embodiment, isolation ring 645 can extend beneath isolation wall 665 or be located entirely beneath isolation wall 665 so that isolation ring 645 is not visible from the viewing angle illustrated in FIG. 6.

For purposes of illustration, fingers 640 are subdivided into four different groups of substantially parallel fingers illustrated as fingers 640A, fingers 640B, fingers 640C, and fingers 640D. Each finger of each group of fingers 640A-640D can couple to isolation ring 645 via one or more contacts (not shown) on one end of each respective finger 640 and extend inward toward a center of coil 605. Fingers 640A extend down from, and are substantially perpendicular to, a top edge of isolation ring 645. Fingers 640B extend left from, and are substantially perpendicular to, a right edge of isolation ring 645. Fingers 640C extend up from, and are substantially perpendicular to, a bottom edge of isolation ring 645. Fingers 640D extend right from, and are substantially perpendicular to, a left edge of isolation ring 645.

Each of fingers 640 can be formed as a metal strip using a process layer that is positioned between the process layer used to form coil 605 and substrate 655. Beneath each linear segment of coil 605, fingers 640 of PGS structure 610 that cross beneath and are in a same group are aligned in parallel with respect to one another. Also, pairs of adjacent fingers in a same group can be separated by a same predetermined distance. In an embodiment, the predetermined distance can be a minimum metal spacing allowed by the IC manufacturing process used to implement inductor structure 600.

For example, fingers 640A can be substantially parallel with respect to one another and substantially perpendicular to the linear segments of coil 605 beneath which each of fingers 640A is located. Further, fingers 640A can be separated from one another by a same predetermined spacing. Appreciably, fingers 640A are not perpendicular to the segment of coil 605 that couples directly to terminal 615. Fingers 640B can be substantially parallel with respect to one another and substantially perpendicular to the linear segments of coil 605 beneath which each of fingers 640B is located. Fingers 640B can be separated from one another by a same predetermined spacing. Fingers 640C are substantially parallel with respect to one another and substantially perpendicular to the linear segments of coil 605 beneath which each of fingers 640C is located. Fingers 6140C can be separated from one another by a same predetermined spacing. Appreciably, fingers 640C are not perpendicular to the segment of coil 605 that couples directly to terminal 620. Fingers 640D are substantially parallel with respect to one another and substantially perpendicular to the linear segments of coil 605 beneath which each of fingers 640D is located. Fingers 640D can be separated from one another by a same predetermined spacing.

Within inductor structure 600, current flow is indicated by arrows 660. Accordingly, each of fingers 640 is oriented substantially perpendicular to the direction of current flow within the segment of coil 605 under which each of fingers 640 is located. By positioning fingers 640 in this manner, the impact of fingers 640 upon the magnetic field generated by the flow of current through coil 605 is reduced. Positioning fingers 640 in this manner can increase the efficiency of inductor structure 600 since the energy stored within the magnetic field surrounding the turns of coil 605 is not obstructed or dissipated by PGS structure 610.

In effect, fingers 640 of PGS structure 610 provide a continuous shield that resides beneath substantially all portions of coil 605. For example, PGS structure 610 can be implemented to extend to at least the outer perimeter defined by an outer edge of coil 605. In an embodiment, each of fingers 640 of PGS structure 610 can extend a predetermined distance beyond the outer perimeter of coil 605. For example, each of fingers 640 can extend a same distance or length beyond the outer perimeter of coil 605.

Isolation wall 665 can be configured to encompass coil 605 and fingers 640. Isolation wall 665 can be implemented with two or more conductive process layers of the IC manufacturing process used to implement inductor structure 600. Isolation wall 665 can be implemented using process layers such as those used to implement coil 605 or fingers 640, for example. In an embodiment, each metal layer of the IC manufacturing process used to implement inductor structure 600 can be stacked vertically to form isolation wall 665. In that case, each pair of vertically adjacent metal layers used to implement isolation wall 665 can be coupled together using one or more vias to form a continuous conductive structure, e.g., wall, around fingers 640.

As pictured in FIG. 6, each of fingers 640 can be coupled to isolation ring 645 via one or more contacts. In that case, isolation wall 665 can be excluded if so desired. In another embodiment, isolation wall 665 can be coupled to the end portion of each of fingers 640 that extends beyond the outer perimeter of coil 605. In that case, isolation wall 665 can be coupled to isolation ring 645 via a plurality of contacts, thereby coupling isolation wall 665 and fingers 640 to substrate 655.

PGS structure 610 can be coupled to a known potential within the IC in which inductor structure 600 is implemented. In a typical P-type substrate IC process, PGS structure 610 can be coupled to a same ground potential, or most negative potential, to which substrate 655 is coupled. Implemented in this manner, PGS structure 610 can form a ground plane that shields substrate 655 from the electric fields generated by currents flowing within inductor structure 600. In addition, PGS structure 610 can isolate inductor structure 600 from noise generated within substrate 655 by other circuit blocks operating within the IC in which PGS structure 610 is implemented.

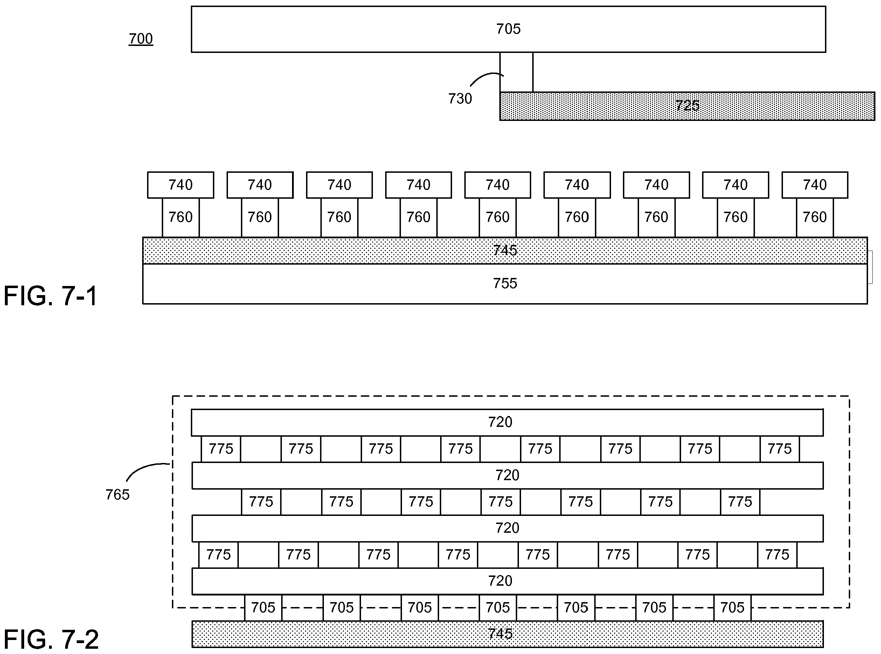

FIGs. 7-1 and 7-1 are sixth and seventh block diagrams each illustrating a side view of an inductor structure 700 in accordance with another embodiment disclosed within this specification. FIGs. 7-1 and 7-1 show a side view of an inductor structure 700, which can be implemented substantially as described with reference to inductor structure 600 of FIG. 6. FIGs. 7-1 and 7-1 are provided as exemplary illustrations. As such, FIGs. 7-1 and 7-1 are not drawn to the same scale as FIG. 6. Further, FIGs. 7-1 and 7-1 illustrate various aspects of inductor structure 700 that are not visible from the topographical view presented in FIG. 6.

FIG. 7-1 illustrates a side view of inductor structure 700 in which the isolation wall, e.g., isolation wall 665 of FIG. 1, is not shown. As pictured, coil 705 of inductor structure 700 is disposed within an upper metal layer, e.g., a metal layer farther or farthest from substrate 755 of the IC manufacturing process used to implement inductor structure 700. Although pictured in FIG. 7-1 as being implemented using a single metal layer, coil 705 can be implemented using two or more vertically stacked metal layers. In that case, adjacent metal layers of coil 705 can be coupled with one or more vias.

It also should be appreciated that coil 705 can be implemented within one or more metal layers located closer, or closest, to substrate 755. Typically, within an IC manufacturing process, metal layers located farther from substrate 755 can be thicker than those that are located closer to substrate 755. Thus, the metal layers farther from substrate 755 tend to have a higher or highest level of conductivity of the available process layers. Therefore, implementing coil 705 in the metal layers farthest from substrate 755 typically provides superior inductor characteristics, for example, lower series resistance for inductor structure 700. However, the implementation of coil 705 with a single conductive layer that is located farthest from substrate 755 as described within this specification is provided for purposes of illustration only, and is not intended as a limitation of the one or more embodiments disclosed herein.

Interconnect 725 is coupled to coil 705 with one or more of vias 730. Interconnect 725 can be implemented in a metal layer that is different from the metal layer used to implement coil 705. Using a different metal layer for interconnect 725 allows the end portion of coil 705, i.e., the end of the inner-most turn of coil 705, to be routed out of coil 705 for coupling to additional IC circuit devices. Although pictured within FIG. 7-1 as being implemented with a single metal layer, interconnect 725 can be implemented with two or more vertically stacked layers of metal. In that case, each adjacent layer in the metal stack forming interconnect 725 can be coupled with one or more vias.

It should be appreciated that interconnect 725 can be implemented within one or more metal layers located above coil 705, i.e., farther from substrate 755 than coil 705. As such, the implementation of interconnect 725 with a single conductive layer located beneath coil 705 as shown within FIG. 7-1 is provided for purposes of illustration and is not intended as a limitation of the one or more embodiments disclosed herein.

Fingers 740 generally are oriented perpendicular to the direction of current flow in the segment of coil 705 under which each of fingers 740 is located. Within FIG. 7-1, only a single group of fingers 740 is illustrated. As shown, each of fingers 740 can be implemented using the metal layer closest to substrate 755. Typically, implementing the PGS structure as close to substrate 755 as possible provides superior isolation between coil 705 and substrate 755. Although illustrated as being implemented in the metal layer closest to substrate 755, fingers 740 can be implemented within any conductive process layer residing between substrate 755 and coil 705. As such, the depiction of fingers 740 being formed in the metal layer closest to substrate 755 within this specification is for purposes of illustration only and is not intended as a limitation of the one or more embodiments disclosed.

In an embodiment, each of fingers 740 can couple at one end to isolation ring 745. Isolation ring 745 can be sized to encompass the entirety of the outer perimeter of coils 705. As shown in FIG. 7-1, each of fingers 740 can couple to isolation ring 745 through one of contacts 760. Isolation ring 745, for example, can be coupled to a ground potential of the IC to create a known constant potential within each of fingers 740 coupled thereto and the portion of substrate 755 located within isolation ring 745. As noted with respect to FIG. 6, reference to isolation ring 745 within this specification also includes contacts 760 (or contacts 705 of FIG. 7-2) unless otherwise indicated or as indicated by context. Isolation ring 745 can be implemented with a low conductivity material such as, for example, a P-type or a P-plus type of diffusion implant. In this manner, each of fingers 740 can be coupled together with low conductance material(s).

FIG. 7-2 illustrates a side view of inductor structure 700 in which isolation wall 765 is shown. Isolation wall 765 can be implemented substantially as described with reference to isolation wall 665 of FIG. 6. As noted, the PGS structure can be implemented with fingers 740 being coupled to isolation ring 745 and, as a result, to substrate 755 (not shown in FIG. 7-2). The PGS structure, however, also can be implemented in a variety of other configurations.

For example, within FIG. 7-2, isolation wall 765 is depicted as being coupled to isolation ring 745 using contacts 705. As such, isolation wall 765 is coupled to substrate 755. In an embodiment, fingers 740 of the PGS structure can be directly coupled to isolation wall 765 as opposed to isolation ring 745. Using this approach, the end portion of each finger 740 can be coupled together using a high conductance material of isolation wall 765, e.g., metal.

As illustrated in FIG. 7-2, isolation wall 765 can include two or more metal layers 720 that are vertically stacked. Each pair of vertically adjacent metal layers 720 can be coupled together using one or more of vias 775. The inter-coupling of multiple metal layers 720 can create a high conductance layer that can be used to couple adjoining fingers 740 within the PGS structure.

In an embodiment, a highest conductive layer used to form isolation wall 765, e.g., the top metal layer 720 shown in FIG. 7-2, can be located at least as far from substrate 755 as the conductive layer used to form coil 705. For example, the highest metal layer 720 can be formed using a same process layer as is used to form coil 705, but also can be built higher so that the highest process layer of isolation wall 765 is farther from substrate 755 than the process layer used to form coil 705. Further, a lowest conductive layer, e.g., the lowest metal layer 720 shown in FIG. 7-2, used to form isolation wall 765 can be located at least as close to substrate 755 as a process layer used to form fingers 740. For example, a lowest metal layer 720 of isolation wall 765 can be implemented using a same process layer as is used to form fingers 740, but also can be formed using a process layer that is located lower, e.g., closer to substrate 755, than the process layer used to form fingers 740.

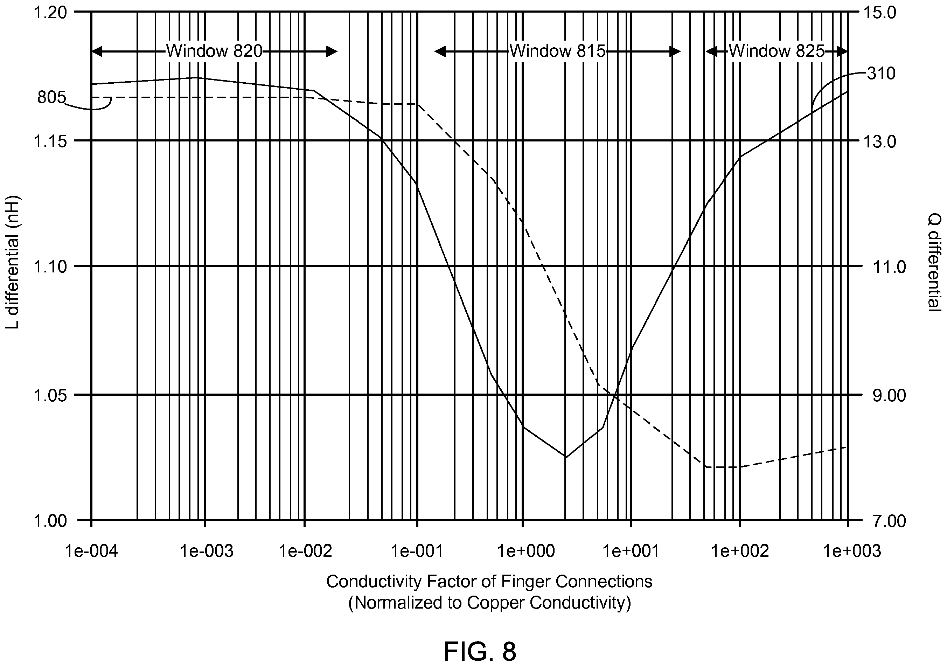

FIG. 8 is a graph illustrating the influence of the conductance of the material used to couple fingers of a PGS structure on the inductive and lossy characteristics of an IC inductor structure in accordance with another embodiment disclosed within this specification. FIG. 8 illustrates the effects of the conductance of the material used to couple individual ones of the fingers of the PGS structure on the inductive value of the inductor structure in which the PGS structure is incorporated, as well as the Q of the inductor structure. The graph of FIG. 8 illustrates an inductance plot 805 and a Q plot 810. The vertical axis is demarcated in nanohenries. The horizontal axis represents conductivity and is demarcated in units that have been normalized to Copper conductivity. The values illustrated by the graph of FIG. 8 are derived from three dimensional electromagnetic simulations.

In a conventional IC inductor structure that utilizes a metal PGS structure, the entire PGS structure is composed of a single, uninterrupted metal layer, e.g., a metal sheet. The uninterrupted PGS structure effectively isolates the substrate under the conventional inductor structure from the electromagnetic field generated by the AC currents flowing within the coil of the conventional inductor structure. In addition, the uninterrupted PGS structure isolates the conventional inductor structure from noise that can propagate from other circuit blocks that neighbor the conventional inductor structure. Within the conventional inductor structure, however, the magnetic field created by AC currents flowing therein generate currents within the uninterrupted PGS structure. The currents induced within the uninterrupted PGS structure of the conventional inductor structure can result in energy losses that can degrade the Q of the conventional inductor structure.

Referring again to FIG. 8, Q and correlated conductance of the material used to interconnect the fingers of the PGS structure is illustrated. Window 815 shows a region of FIG. 8 in which Q plot 810 is degraded. The degradation of Q associated with the PGS structure results in an inductor structure that is inadequate for radio frequency (RF) IC circuits. Q plot 810 demonstrates that two ranges of conductance for the material used to interconnect the fingers of the PGS structure can result in improved Q for an inductor structure.

Window 820 illustrates that decreased conductance of the material used to interconnect the fingers of the PGS structure corresponds with an increase in Q and inductance of the inductor structure. The increase in Q demonstrated by Q plot 810 and the increase in inductance demonstrated by inductance plot 805 that occur within window 820 result from the low conductance of the material used to interconnect the fingers of the PGS structure preventing currents from flowing between the fingers. The currents that are prevented, or inhibited, from flowing between the fingers of the PGS structure are induced by the electric field that is generated by AC currents within the inductor structure. Preventing the current flow between fingers can decrease resistive losses within the PGS structure that tend to increase the Q of the inductor structure.

Window 825 illustrates that increased conductance of the material used to interconnect the fingers of the PGS structure corresponds to an increase in Q and a decrease in inductance of the inductor structure. The increase in Q demonstrated by Q plot 810 and the decrease in inductance demonstrated by inductance plot 805 that occur within window 825 result from the high conductance of the material used to interconnect the fingers of the PGS structure significantly reducing the resistance between the fingers. Reducing the inter-finger resistance, e.g., the resistance between fingers, can decrease the resistive losses that occur within the PGS structure that tend to increase the Q of the inductor structure.

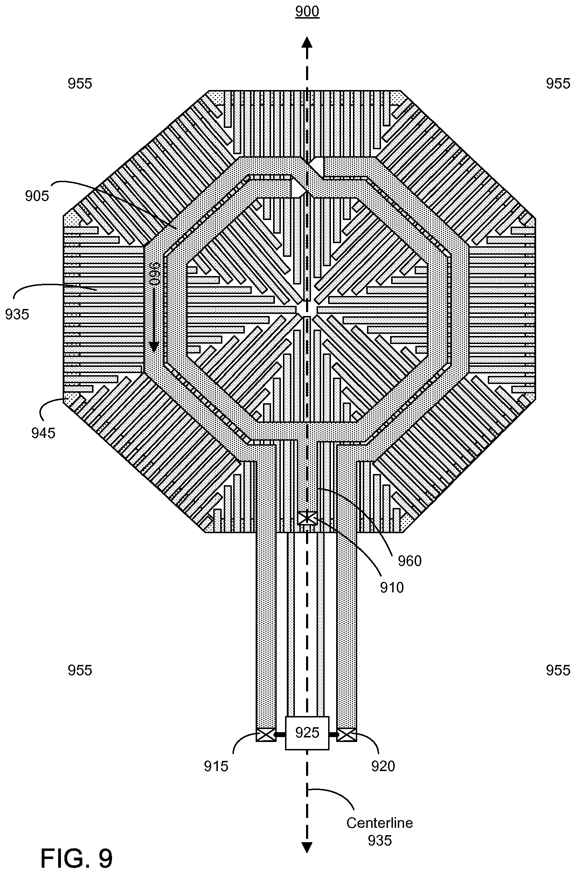

FIG. 9 is a eighth block diagram illustrating a topographical view of an inductor structure 900 in accordance with another embodiment disclosed within this specification. FIG. 9 illustrates a physical layout of inductor structure 900 within an IC. As shown, inductor structure 900 is pictured as a two turn, center tap inductor structure. Inductor structure 900 can be implemented to utilize properties illustrated in window 820 of FIG. 8, e.g., low conductivity in the material used to interconnect fingers of the PGS structure.

Inductor structure 900 can include a coil 905, a center terminal 910, differential terminals (terminals) 915 and 920, a circuit block 925, and an isolation ring 945. As shown, circuit block 925 can couple to the linear segments, e.g., "legs," of coil 905 that extend outward past isolation ring 945. Circuit block 925 can couple to legs of coil 905, e.g., to terminals 915 and 920, via one or more connections or terminals, as shown. In an embodiment, a ground metal can be located and implemented under circuit block 925 and can be formed of a low loss material. A return line 960 of conductive material can be coupled to coil 905 in a fashion similar to that shown in FIG. 5. The return line can be positioned on centerline 935.

Although denoted as four distinct objects for descriptive purposes within this specification, coil 905, center terminal 910, and terminals 915 and 920 are coupled together and can represent one continuous area of conductive material. In addition, though implemented as one continuous area or segment of conductive material, coil 905, center terminal 910, and terminals 915 and 920 can be implemented within one or more different conductive, e.g., metal, process layers of the IC. The conductive layers can be coupled together using one or more vias to create one continuous conductive pathway.

Coil 905 can be implemented as a symmetrical, two turn coil of inductor structure 900. A centerline 935 can be determined that symmetrically bisects, or substantially symmetrically bisects, coil 905. Although implemented as an octagonal coil within FIG. 9, coil 905 can be implemented in any of a variety of forms or shapes that can be implemented using available IC manufacturing processes, so long as the symmetry of coil 905 about centerline 935 is retained. As such, the implementation of coil 905 as an octagonal coil within inductor structure 900 is provided for purposes of illustration and is not intended as a limitation of the one or more embodiments disclosed within this specification.

A PGS structure can be implemented between the conductive process layer used to implement coil 905 and substrate 955. The PGS structure can reside beneath, and extend beyond, an outer perimeter defined by an outer edge of coil 905. The PGS structure can include, and thus, be characterized by, a plurality of fingers 935 and an isolation ring 945. Each of fingers 935 can be positioned substantially perpendicular to the segment of coil 905 beneath which that finger 935 extends. As such, each finger 935 is substantially perpendicular to the flow of current through that segment of coil 905. As pictured in FIG. 9, each finger 935 of the PGS structure is coupled on one end to isolation ring 945. Coil 905 can be concentric with isolation ring 945, which is positioned to encompass coil 905 by substantially a constant distance from the outer edge of coil 905.

Isolation ring 945 can be located along the distal end of each finger 935 within the PGS structure of inductor structure 900 that extends outward past the outer perimeter of coil 905. Each finger 935 can be coupled to isolation ring 945 on one end, e.g., at the "distal" end, with one or more contacts (not shown). Isolation ring 945 can be formed or composed of a low conductance material having a conductance that is within the range defined by window 820 of FIG. 8. In an embodiment, the material used to implement isolation ring 945 can be a low conductance, P-type diffusion that is implanted within substrate 955. Coupling together fingers 935 of inductor structure 900 with the high resistance material of the P-type diffusion can reduce current flow between fingers 935. The reduced current flow between fingers 935 can lead to losses within inductor structure 900. Reducing these resistive losses can improve the Q of inductor structure 900.

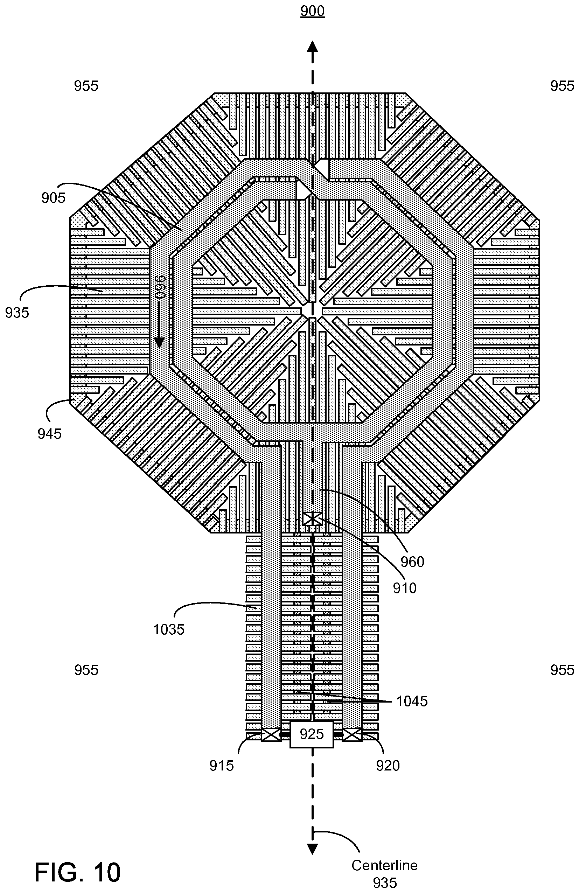

FIG. 10 is a ninth block diagram illustrating a topographical view of inductor structure 900 of FIG. 9 in accordance with another embodiment disclosed within this specification. More particularly, FIG. 10 illustrates an embodiment having a physical refinement that can improve the Q of inductor structure 900.

Referring to FIG. 10, parallel fingers 1035 are located beneath the segments of coil 905 that extend beyond the turns of coil 905 and isolation ring 945 of the PGS structure of inductor structure 900 to form differential terminal 915 and 920. Fingers 1035, which can be implemented as metal strips substantially similar to fingers 935, can be coupled to linear segments 1045. In an embodiment, linear segments 1045 can couple to isolation ring 945. Linear segments 1045 can be formed of the same low conductance material that is used to form isolation ring 945. Each of fingers 1035 can be coupled to linear segments 1045 through one or more contacts (not shown). In the example pictured in FIG. 10, fingers 1035 can be arranged in two columns, where each column is positioned beneath one leg of coil 905. Each of fingers 1035 is substantially perpendicular to the legs of coil 905.

The addition of fingers 1035 and linear segments 1045 beneath the legs of coil 905 prevent the generation of eddy currents within substrate 955 from electromagnetic fields associated with currents flowing through inductor structure 900. By coupling together fingers 1035 beneath the legs of coil 905 using linear segments 1045, current is prevented from flowing between fingers 1035. Decreasing the ability to generate eddy currents within substrate 955 and preventing resistive losses within fingers 1035 beneath the legs of coil 905 can further reduce losses that can be incurred within inductor structure 900. This reduction in loss further can improve the Q of inductor structure 900.

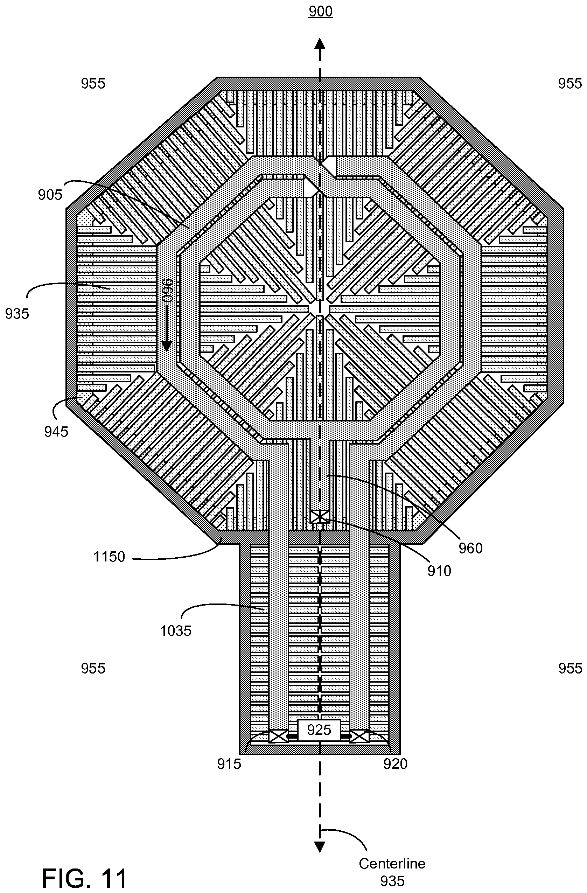

FIG. 11 is a tenth block diagram illustrating a topographical view of inductor structure 900 of FIG. 9 in accordance with another embodiment disclosed within this specification. FIG. 11 illustrates a physical refinement of inductor structure 900 that can provide additional Q improvement to inductor structure 900. FIG. 11 illustrates an embodiment that makes use of highly conductive material. The conductive material utilized in FIG. 11, for example, can have a conductivity that is within a range defined by window 825 of FIG. 8. The conductive material can be used to couple fingers 935 and 1035 within the PGS structure of inductor structure 900. Inductor structure 900 further can include isolation wall 1150.

Referring to FIG. 11, the outer perimeter of the PGS structure of inductor structure 900 is surrounded by an isolation wall 1150. As previously described, an isolation wall such as isolation wall 1150 can include two or more metal layers that are vertically stacked. Each pair of vertically adjacent metal layers can be coupled together using one or more vias. The inter-coupling of multiple metal layers creates a high conductance path that can be used to couple adjoining fingers 935 of the PGS structure and fingers 1035. In this manner, each pair of adjoining fingers can be coupled with a high conductance material.

In an embodiment, the metal layer(s) used to implement isolation wall 1150 can include one or more or all metal layers of the IC manufacturing process in which inductor structure 900 is implemented. In another embodiment, isolation wall 1150 can include, at least, the metal layers used to implement coil 905 and the metal layer used to implement the PGS structure of inductor structure 900, e.g., the metal layer used to implement fingers 935 and/or 1035. In either case, each pair of vertically adjacent metal layers can be coupled by one or more vias or stacks of vias.

As discussed, using a material that has a conductance within window 825 of FIG. 8 to connect fingers 935 and 1035 of the PGS structure effectively decreases the resistance of the material connecting the metal strips of the PGS structure. Decreasing this resistance decreases resistive losses in the PGS structure of inductor structure 900 and, accordingly, increases the Q of inductor structure 900. The increase in Q associated with window 825 results from the high conductance of the material connecting the fingers 935 and 1035 of the PGS structure, which greatly reduces the resistance between fingers 935 and 1035 within the PGS structure.

In an embodiment, the portion of isolation wall 1150 through which each of the legs of coil 905 crosses can be at least partially discontinuous. More particularly, one or more conductive layers used to form isolation wall 1150 can be discontinued or interrupted so as to allow each of the legs of coil 905 to cross isolation wall 1150. Though one or more conductive layers that form isolation wall 1150 can have a discontinuity to allow each respective leg to pass, it should be appreciated that not all layers of isolation wall 1150 need have a discontinuity or gap.

Isolation ring 945 can be located beneath isolation wall 1150. Isolation ring 945 can be coupled to the lowest metal layer used to form isolation wall 1150 using one or more contacts. As noted, isolation ring 945 can be sized as shown, can extend beneath isolation wall 1150, or can be located completely beneath isolation wall 1150 so as to not be visible in the example shown.

In an embodiment, fingers 935 and 1035 can be formed using a lowest metal layer that is used to form isolation wall 1150. In this regard, fingers 935 and 1035 can be formed as part of the isolation wall

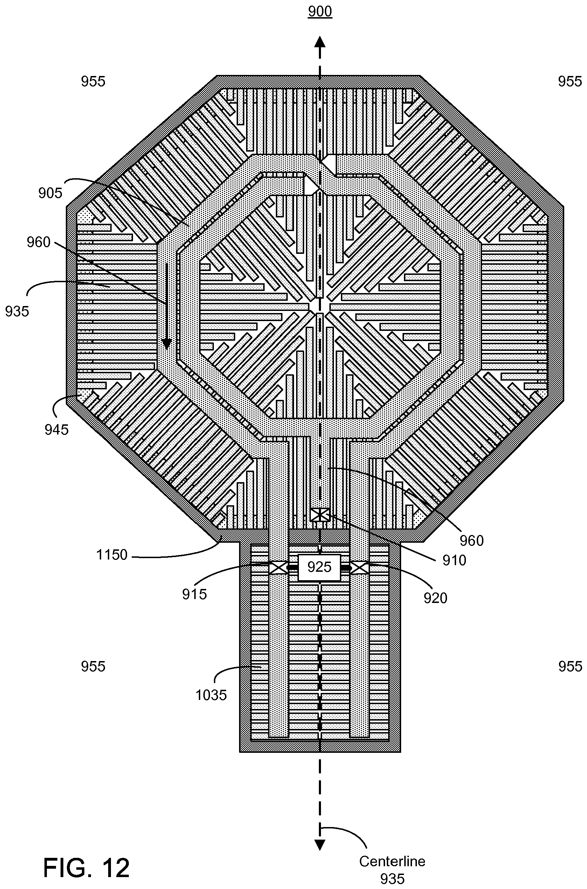

FIG. 12 is an eleventh block diagram illustrating a topographical view of inductor structure 900 of FIG. 9 in accordance with another embodiment disclosed within this specification. FIG. 12 illustrates an embodiment in which a further physical refinement of inductor structure 900 is shown that can increase the Q of inductor structure 900.

Typically, inductor structures are used as RF circuit components within an IC. For example, a center tap inductor such as inductor structure 900 is often used when implementing a differential RF voltage controlled oscillator (VCO). In that case, circuit block 925 can be a cross coupled gm cell that forms the core of the RF VCO. The physical location of the source connections of the gm cell, also representing an electrical node, can correspond to a virtual AC ground of the RF VCO circuit for differential current flowing within coil 905.

As used within this specification, the term "virtual AC ground," can refer to a node of a circuit that is maintained at a steady voltage potential when sourcing or sinking AC current without being directly physically coupled to a reference voltage potential. In an embodiment, circuit block 925 can be repositioned along the linear segments of coil 905. A virtual AC ground can be located within circuit block 925, e.g., at a node where two sources of a differential transistor pair of the gm cell are coupled. The virtual AC ground within circuit block 925 can be coupled to an actual ground of the IC in the same or similar manner as isolation wall 1150, e.g., where multiple conductive layers are vertically coupled through vias to form a low loss path, thereby providing further improvement in Q for inductor structure 900.

In addition, shifting the position of circuit block 925 to a location that is substantially adjacent to a portion of the isolation wall 1150 where legs of coil 905 extend beyond can provide additional Q improvement in inductor structure 900. Referring to FIG. 12, the location of circuit block 925 and terminals 915 and 920 has been altered from residing at or about endpoints of the legs of coil 905, e.g., farther away from coil 905 as shown in FIG. 11, to the location illustrated in FIG. 12.

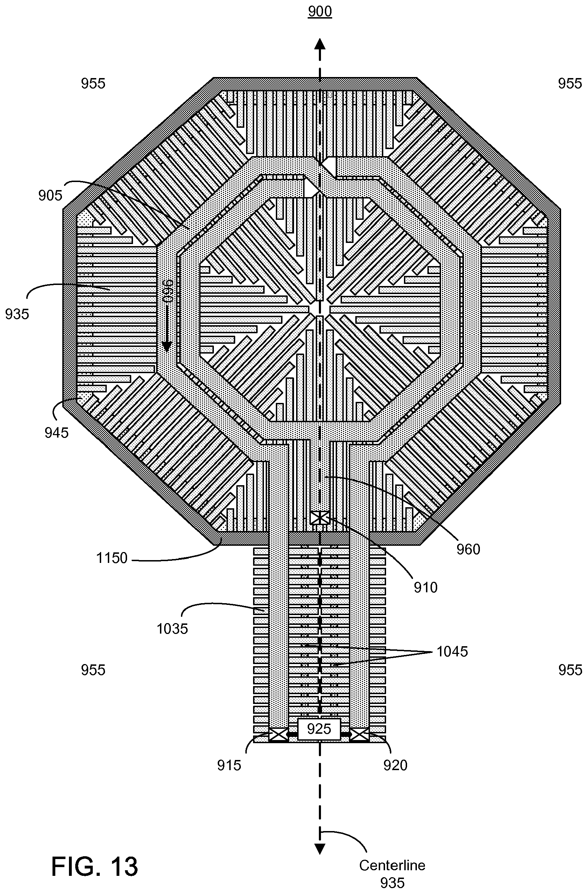

FIG. 13 is a twelfth block diagram illustrating a topographical view of the inductor structure of FIG. 9 in accordance with another embodiment disclosed within this specification. FIG. 13 illustrates an embodiment in which isolation wall 1150 surrounds only coils 905 of inductor structure 900. Accordingly, whereas fingers 935 can couple to isolation wall 1150 as described with reference to FIGs. 11 and 12, fingers 1035 can couple to linear segments 1045 via a plurality of contacts. Linear segments 1045 can couple to isolation ring 945 disposed beneath isolation wall 1150. In the example pictured in FIG. 13, circuit 925 is located near the ends of the legs of coil 905. In this regard, contacts 915 and 920 also are located near the ends of the legs, e.g., at approximately a farthest location on the legs away from coil 905.

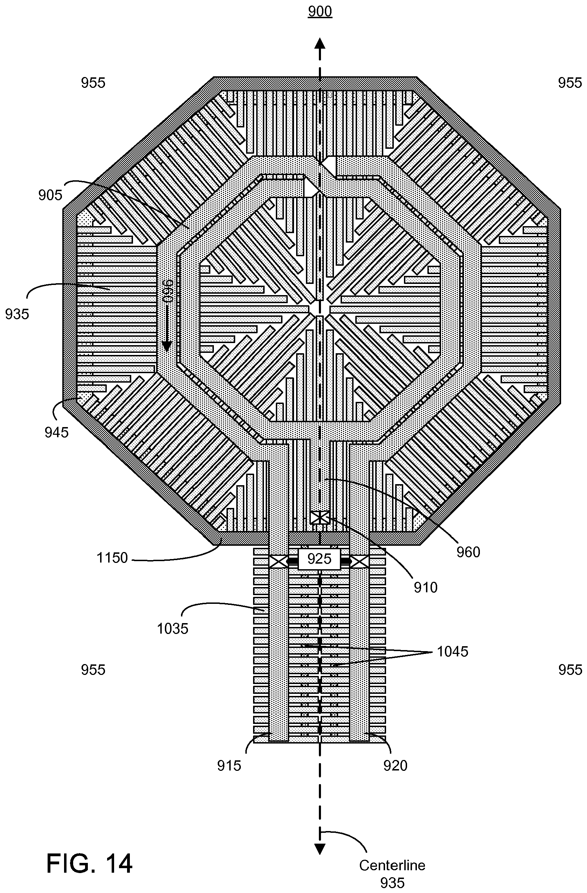

FIG. 14 is a thirteenth block diagram illustrating a topographical view of the inductor structure of FIG. 9 in accordance with another embodiment disclosed within this specification. FIG. 14, like FIG. 13, illustrates an embodiment in which isolation wall 1150 surrounds only coils 905 of inductor structure 900. Fingers 935 can couple to isolation wall 1150 as described with reference to FIGs. 11 and 12. Fingers 1035 can couple to linear segments 1045 via a plurality of contacts. In the example pictured in FIG. 14, circuit 925 is located near the ends of the legs of coil 905 that are closest to coil 905. In this regard, contacts 915 and 920 also are located at or about the ends of the legs, e.g., at approximately a closest location on the legs to coil 905.

One or more embodiments disclosed within this specification provide a center tap IC inductor structure that demonstrates improved matching characteristics and improved immunity to coupling effects than conventional inductor structures. The IC inductor structure can be built symmetrically with respect to a centerline that bisects the center tap of the IC inductor structure.

In some embodiments, an isolation ring can be built that surrounds the outer perimeter of the coils of the center tap IC inductor structure. The isolation ring can be discontinuous in that the isolation ring can include an opening centered about the centerline. The discontinuity in the isolation ring impedes induced current from flowing within the isolation ring. In the case of a single turn center tap inductor structure, a return line in a different conductive layer than the coil can be added to the inductor structure. In the case of multiple-turn center tap inductor structures, the return line can be in a same conductive layer as the coil. The return line can be centered symmetrically along the centerline and return current can be sourced from the IC inductor structure on a path that symmetrically bisects the single turn coil of the IC inductor structure.

In some embodiments, the center tap inductor structure can include a patterned ground shield including a plurality of fingers implemented within an IC process layer located between the coils of the center tap IC inductor structure and a substrate of the IC. The isolation ring can be coupled to one end of each finger.

In some embodiments, an isolation wall comprising a high conductive material can be formed to encompass the coil and the patterned ground shield. The isolation wall can be coupled to one end of each finger, and/or to the substrate of the IC. The isolation wall can include a plurality of vertically stacked conductive layers, where each pair of adjacent, vertically stacked conductive layers is coupled by a via. A highest conductive layer used to form the isolation wall can be implemented using a process layer at least as far from the substrate of the IC as a process layer used to form the coil. A lowest conductive layer used to form the isolation wall can be implemented using a process layer at least as close to the substrate of the IC as a process layer used to form the plurality of fingers.

The terms "a" and "an," as used herein, are defined as one or more than one. The term "plurality," as used herein, is defined as two or more than two. The term "another," as used herein, is defined as at least a second or more. The terms "including" and/or "having," as used herein, are defined as comprising, i.e., open language. The term "coupled," as used herein, is defined as connected, whether directly without any intervening elements or indirectly with one or more intervening elements, e.g., circuit components such as one or more active and/or passive devices, unless otherwise indicated. Two elements also can be coupled mechanically, electrically, or communicatively linked through a communication channel, pathway, network, or system.

## Claims

1. An inductor structure implemented within a semiconductor integrated circuit (IC), the inductor structure comprising:
a coil (205) of conductive material that comprises a center terminal (140) located at a midpoint of a length of the coil;
wherein the coil is symmetrical with respect to a centerline (225) bisecting the center terminal;
wherein the coil comprises a first differential terminal (210) and a second differential terminal (215) each located at an end of the coil; and
a return line (155) of conductive material, wherein the return line is positioned on the centerline; and
an isolation ring (220) that surrounds the coil and is separated from the coil by a constant and predetermined distance, wherein the isolation ring is coupled to the return line at a location (250) opposite the center terminal.

2. The inductor structure of claim 1, wherein the isolation ring comprises a first end (240) and a second end (245) separated by a predetermined distance (235) forming an opening.

3. The inductor structure of claim 1 or claim 2, wherein the isolation ring (220) is coupled, at a midpoint of a length of the isolation ring, to a ground node (250) in a circuit in which the inductor structure is implemented, wherein the ground node is maintained at a steady voltage potential when sourcing or sinking AC current without being directly physically coupled to a reference voltage potential.

4. The inductor structure of claim 2 or claim 3, wherein the first end (240) and the second end (245) of the isolation ring (220) are equidistant from the centerline.

5. The inductor structure of any of claims 2-4, wherein:
no supply voltage interconnect and no ground interconnect are located within the isolation ring; and
no supply voltage interconnect and no ground interconnect cross the centerline within a predetermined distance of the isolation ring.

6. The inductor structure of any of claims 1-5, wherein:
the first differential terminal (210) and the second differential terminal (215) are each located at an end of the coil opposite the center terminal (140);
the return line (155) is located in a different conductive layer than the coil (205); and
a length of the return line is equal to a diameter of the coil at the centerline.

7. The inductor structure of any of claims 1-6, further comprising:
a patterned ground shield comprising a plurality of fingers (935, 1035) implemented within an IC process layer located between the coil of conductive material and a substrate (955) of the IC.

8. The inductor structure of claim 7, wherein:
the coil (905) is formed of a plurality of linear segments;
for each of the plurality of linear segments of the coil, the plurality of fingers (935, 1035) located below that linear segment are parallel and separated by a predetermined distance from one another; and
each finger is positioned perpendicular to the linear segment of the coil beneath which the each finger is located.

9. The inductor structure of any of claims 7-8, wherein the isolation ring (945) is coupled to one end of each finger.

10. The inductor structure of any of claims 7-9, further comprising:
an isolation wall (1150) comprising a high conductive material formed to encompass the coil (905) and the patterned ground shield,
wherein the isolation wall is coupled to one end of each finger.

11. The inductor structure of claim 10, wherein the isolation wall (1150) is coupled to the substrate (955) of the IC.

12. The inductor structure of claim 10 or claim 11, wherein:
the isolation wall (1150) comprises a plurality of vertically stacked conductive layers;
each pair of adjacent, vertically stacked conductive layers is coupled by a via;
a highest conductive layer used to form the isolation wall is implemented using a process layer at least as far from the substrate of the IC as a process layer used to form the coil; and
a lowest conductive layer used to form the isolation wall is implemented using a process layer at least as close to the substrate of the IC as a process layer used to form the plurality of fingers.

13. An integrated circuit (IC) comprising the inductor structure of any of claims 1-12.

## Patentansprüche

1. Induktorstruktur, implementiert in einer integrierten Halbleiterschaltung (IC), wobei die Induktorstruktur Folgendes beinhaltet:
eine Spule (205) aus leitfähigem Material, beinhaltend einen Mittelanschluss (140), angeordnet in einem Mittelpunkt einer Länge der Spule;
wobei die Spule symmetrisch in Bezug auf eine Mittellinie (225) ist, welche den Mittelanschluss kreuzt;
wobei die Spule einen ersten Differenzialanschluss (210) und einen zweiten Differenzialanschluss (215) beinhaltet, die jeweils an einem Ende der Spule angeordnet sind; und eine Rücklaufleitung (155) aus leitfähigem Material, wobei die Rücklaufleitung auf der Mittellinie positioniert ist; und
einen Isolationsring (220), der die Spule umgibt und von der Spule durch einen konstanten und vorbestimmten Abstand getrennt ist, wobei der Isolationsring an einer Position (250) gegenüber dem Mittelanschluss mit der Rücklaufleitung verbunden ist.

2. Induktorstruktur nach Anspruch 1, bei welcher der Isolationsring ein erstes Ende (240) und ein zweites Ende (245) beinhaltet, welche durch einen vorbestimmten Abstand (235) getrennt sind, welcher eine Öffnung definiert.

3. Induktorstruktur nach Anspruch 1 oder 2, bei welcher der Isolationsring (220) an einem Mittelpunkt der Länge des Isolationsrings mit einem Erdungsknoten (250) in einem Kreislauf verbunden ist, in welchem die Induktorstruktur implementiert ist, wobei der Erdungsknoten bei der Lieferung oder Senkung von Wechselstrom bei konstantem Spannungspotenzial gehalten wird, ohne direkt physikalisch mit einem Referenzspannungspotenzial verbunden zu sein.

4. Induktorstruktur nach Anspruch 2 oder 3, bei welcher das erste Ende (240) und das zweite Ende (245) des Isolationsrings (220) in gleichem Abstand von der Mittellinie sind.

5. Induktorstruktur nach einem der Ansprüche 2 bis 4, bei welcher:
keine Versorgungsspannungs- und keine Erdungsverbindung innerhalb des Isolationsrings angeordnet ist; und
keine Versorgungsspannungs- und keine Erdungsverbindung die Mittellinie innerhalb eines vorbestimmten Abstandes vom Isolationsring kreuzt.

6. Induktorstruktur nach einem der Ansprüche 1 bis 5, bei welcher:
der erste Differenzialanschluss (210) und der zweite Differenzialanschluss (215) jeweils an einem Ende der Spule gegenüber vom Mittelanschluss (140) angeordnet sind;
die Rückführleitung (155) in einer unterschiedlichen Leitschicht angeordnet ist als die Spule (205); und
eine Länge der Rückführleitung mit einem Durchmesser der Spule an der Mittellinie identisch ist.

7. Induktorstruktur nach einem der Ansprüche 1 bis 6, bei welcher:
eine gemusterte Erdungsschirmung, beinhaltend eine Vielzahl von Fingern (935, 1035), welche in einer Prozess-Schicht eines integrierten Schaltkreises zwischen der Spule aus leitfähigem Material und einem Substrat (955) des integrierten Schaltkreises implementiert ist.

8. Induktorstruktur nach Anspruch 7, bei welcher:
die Spule (905) aus einer Vielzahl von linearen Segmenten gebildet ist;
bei jedem dieser Vielzahl von linearen Segmenten der Spule, die Vielzahl von Fingern (935, 1035), welche unterhalb dieses linearen Segments angeordnet sind, zueinander parallel und voneinander durch einen vorbestimmten Abstand getrennt sind; und
jeder Finger rechtwinklig zum linearen Segment derjenigen Spule positioniert ist, unter welcher der jeweilige Finger angeordnet ist.

9. Induktorstruktur nach einem der Ansprüche 7 bis 8, bei welchem der Isolationsring (945) mit einem Ende eines jeden Fingers verbunden ist.

10. Induktorstruktur nach einem der Ansprüche 7 bis 9, weiterhin beinhaltend:
eine Isolationswand (1150), beinhaltend ein hochleitfähiges Material, geformt zum Umfassen der Spule (905) und der gemusterten Erdungsschirmung,
wobei die Isolationswand mit einem Ende eines jeden Fingers verbunden ist.

11. Induktorstruktur nach Anspruch 10, bei welcher die Isolationswand (1150) mit dem Substrat (955) des integrierten Schaltkreises verbunden ist.

12. Induktorstruktur nach Anspruch 10 oder 11, bei welcher:
die Isolationswand (1150) eine Vielzahl von vertikal gestapelten leitfähigen Schichten beinhaltet;
jedes Paar von benachbarten, vertikal gestapelten leitfähigen Schichten durch eine Durchgangsleitung verbunden ist;
eine Schicht mit der höchsten Leitfähigkeit, die zur Bildung der Isolationswand verwendet wird, unter Verwendung einer Prozess-Schicht implementiert wird, die mindestens so weit vom Substrat des integrierten Schaltkreises entfernt ist, wie eine zur Bildung der Spule verwendete Prozess-Schicht; und
eine Schicht mit der niedrigsten Leitfähigkeit, die zur Bildung der Isolationswand verwendet wird, unter Verwendung einer Prozess-Schicht implementiert wird, die mindestens so nah am Substrat des integrierten Schaltkreises angeordnet ist, wie eine zur Bildung der Vielzahl von Fingern verwendete Prozess-Schicht.

13. Integrierter Schaltkreis (IC), der die Induktorstruktur nach einem der Ansprüche 1 bis 12 beinhaltet.

## Revendications

1. Structure d'inducteur mise en oeuvre au sein d'un circuit intégré à semiconducteurs (CI), la structure d'inducteur comprenant :
une bobine (205) de matériau conducteur qui comprend une borne centrale (140) située au niveau d'un point médian d'une longueur de la bobine ;
dans laquelle la bobine est symétrique par rapport à un axe médian (225) coupant en deux la borne centrale ;
dans laquelle la bobine comprend une première borne différentielle (210) et une deuxième borne différentielle (215) situées respectivement au niveau d'une extrémité de la bobine ; et
une ligne de retour (155) en un matériau conducteur, dans laquelle la ligne de retour est positionnée sur l'axe médian ; et
un anneau isolant (220) qui entoure la bobine et est séparé de la bobine par une distance constante et prédéterminée, dans laquelle l'anneau isolant est couplé à la ligne de retour au niveau d'un emplacement (250) situé à l'opposé de la borne centrale.

2. Structure d'inducteur selon la revendication 1, dans laquelle l'anneau isolant comprend une première extrémité (240) et une deuxième extrémité (245) séparées par une distance prédéterminée (235) formant une ouverture.

3. Structure d'inducteur selon la revendication 1 ou 2, dans laquelle l'anneau isolant (220) est couplé, au niveau d'un point médian d'une longueur de l'anneau isolant, à un noeud de mise à la terre (250) dans un circuit au sein duquel est mise en oeuvre la structure d'inducteur, dans laquelle le noeud de mise à la terre est maintenu à un potentiel de tension constant lorsqu'on procure ou que l'on soutire du courant CA sans être couplé physiquement et directement à un potentiel de tension de référence.

4. Structure d'inducteur selon les revendications 2 ou 3, dans laquelle la première extrémité (240) et la deuxième extrémité (245) de l'anneau isolant (220) sont équidistantes par rapport à l'axe médian.

5. Structure d'inducteur selon l'une quelconque des revendications 2 à 4, dans laquelle :
aucune interconnexion de tension d'alimentation et aucune interconnexion de mise à la terre n'est située au sein de l'anneau isolant ; et
aucune interconnexion de tension d'alimentation et aucune interconnexion de mise à la terre ne croise l'axe médian à moins d'une distance prédéterminée de l'anneau isolant.

6. Structure d'inducteur selon l'une quelconque des revendications 1 à 5, dans laquelle :
la première borne différentielle (210) et la deuxième borne différentielle (215) sont situées respectivement au niveau d'une extrémité, située à l'opposé de la borne centrale (140) de la bobine ;
la ligne de retour (155) est située dans une couche conductrice différente de celle de la bobine (205) ; et
une longueur de la ligne de retour est égale à un diamètre de la bobine au niveau de l'axe médian.

7. Structure d'inducteur selon l'une quelconque des revendications 1 à 6, comprenant en outre :
une protection de mise à la terre profilée comprenant une pluralité de doigts (935, 1035) est mise en oeuvre au sein d'une couche de traitement de CI située entre la bobine de matériau conducteur et un substrat (955) du CI.

8. Structure d'inducteur selon la revendication 7, dans laquelle :
la bobine (905) est formée d'une pluralité de segments linéaires ;
pour chacun parmi la pluralité de segments linéaires de la bobine, la pluralité de doigts (935, 1035) situés en dessous dudit segment linéaire sont parallèles et séparés par une distance prédéterminée les uns par rapport aux autres ; et
chaque doigt est positionné perpendiculaire au segment linéaire de la bobine en dessous duquel est situé le doigt respectif.

9. Structure d'inducteur selon la revendication 7 ou 8, dans laquelle l'anneau isolant (945) est couplé à une extrémité de chaque doigt.

10. Structure d'inducteur selon l'une quelconque des revendications 7 à 9, comprenant en outre :
une paroi isolante (1150) comprenant un matériau hautement conducteur formé de manière à inclure la bobine (905) et la protection de mise à la terre profilée,
dans laquelle la paroi isolante est couplée à une extrémité de chaque doigt.

11. Structure d'inducteur selon la revendication 10, dans laquelle la paroi isolante (1150) est couplée au substrat (955) du CI.

12. Structure d'inducteur selon la revendication 10 ou 11, dans laquelle :
la paroi isolante (1150) comprend une pluralité de couches conductrices empilées verticalement ;
chaque paire de couches conductrices adjacentes empilées verticalement est couplée grâce à un via ;
une couche la plus conductrice utilisée pour former la paroi isolante est mise en oeuvre en utilisant une couche de traitement au moins aussi éloignée du substrat du CI qu'une couche de traitement utilisée pour former la bobine ; et
une couche la moins conductrice utilisée pour former la paroi isolante est mise en oeuvre en utilisant une couche de traitement au moins aussi proche du substrat du CI qu'une couche de traitement utilisée pour former la pluralité de doigts.

13. Circuit intégré (CI) comprenant la structure d'inducteur selon l'une quelconque des revendications 1 à 12.
